(19) **Europäisches Patentamt / European Patent Office / Office européen des brevets**

(11) **EP 3 923 331 A1**

(12) **EUROPEAN PATENT APPLICATION**
published in accordance with Art. 153(4) EPC

(43) Date of publication:
**15.12.2021 Bulletin 2021/50**

(21) Application number: **20752006.5**

(22) Date of filing: **23.01.2020**

(51) Int Cl.:
**H01L 27/146** (2006.01)     **H04N 5/369** (2011.01)

(86) International application number:
**PCT/JP2020/002238**

(87) International publication number:
**WO 2020/162196 (13.08.2020 Gazette 2020/33)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **06.02.2019   JP 2019019629**

(71) Applicant: **Sony Semiconductor Solutions Corporation**
**Atsugi-shi, Kanagawa 243-0014 (JP)**

(72) Inventors:
• **YOKOGAWA, Sozo**
  **Atsugi-shi, Kanagawa 243-0014 (JP)**
• **HAGIWARA, Hiroki**
  **Tokyo 108-0075 (JP)**

(74) Representative: **Müller Hoffmann & Partner**
**Patentanwälte mbB**
**St.-Martin-Strasse 58**
**81541 München (DE)**

(54) **IMAGING DEVICE AND IMAGING SYSTEM**

(57)     An imaging device includes: a semiconductor substrate having a first surface and a second surface opposed to each other, and provided with a plurality of pixels; a wiring layer which is provided on side of the second surface of the semiconductor substrate and to which a signal is to be transmitted for each of the plurality of pixels; a light-blocking film opposed to the wiring layer with the semiconductor substrate interposed therebetween and having an opening satisfying Expression (1) below for each of the pixels; and a waveguide provided on side of the first surface of the semiconductor substrate for each of the plurality of pixels and extending to the opening of the light-blocking film.

$$B < A \ ..... \ (1) \qquad (1)$$

where B is an area of the opening in each pixel, and A is an area of the first surface covered with the light-blocking film in each pixel.

[ FIG. 1 ]

EP 3 923 331 A1

## Description

Technical Field

The present disclosure relates to an imaging device and an imaging system, the imaging device including a semiconductor substrate and a wiring layer.

Background Art

Recently, development of an imaging device that receives light having a wavelength in the near-infrared region has advanced. Such an imaging device is applied to, for example, a distance measurement system or the like for obtaining information about a distance from a predetermined point to a target (for example, see PTL 1).

Citation List

Patent Literature

PTL 1: Japanese Unexamined Patent Application Publication No. 2017-150893

Summary of the Invention

Regarding such an imaging device, reflection and diffraction of light inside the imaging device can exert an influence on imaging information.

Therefore, it is desirable to provide an imaging device that makes it possible to reduce the influence of the reflection and diffraction of light inside the imaging device on imaging information, and an imaging system including the imaging device.

An imaging device according to an embodiment of the present disclosure includes: a semiconductor substrate having a first surface and a second surface opposed to each other, and provided with a plurality of pixels; a wiring layer which is provided on side of the second surface of the semiconductor substrate and to which a signal is to be transmitted for each of the plurality of pixels; a light-blocking film opposed to the wiring layer with the semiconductor substrate interposed therebetween and having an opening satisfying Expression (1) below for each pixel; and a waveguide provided on side of the first surface of the semiconductor substrate for each of the plurality of pixels and extending to the opening of the light-blocking film.

$$B < A \ ..... \ (1)$$

where B is an area of the opening in each pixel, and A is an area of the first surface covered with the light-blocking film in each pixel.

An imaging system according to an embodiment of the present disclosure includes the imaging device according to the above-described embodiment of the present disclosure, and an arithmetic processing unit to which a signal from the imaging device is to be inputted.

In the imaging device and the imaging system according to the respective embodiments of the present disclosure, the opening of the light-blocking film satisfies Expression (1). That is, in each pixel, a region covered with the light-blocking film has an area greater than the area of the opening of the light-blocking film. As a result, light reflected or diffracted at an interface between the semiconductor substrate and the wiring layer or in the wiring layer enters the light-blocking film, and is thus not easily radiated from the first surface of the semiconductor substrate to the outside of the semiconductor substrate.

It is to be noted that the above-described content is an example of the present disclosure. The effects of the present disclosure are not limited to those described above, and may be other different effects, or may further include other effects.

Brief Description of the Drawings

[FIG. 1] FIG. 1 is a schematic cross-sectional diagram illustrating a configuration of a main part of an imaging device according to an embodiment of the present disclosure.
[FIG. 2] FIG. 2 is a diagram illustrating an example of a configuration of a pixel circuit of the imaging device illustrated in FIG. 1.
[FIG. 3] FIG. 3 is a schematic diagram illustrating a planar configuration of a light-blocking film, etc. illustrated in FIG. 1.
[FIG. 4] FIG. 4 is a schematic diagram illustrating another example of the planar configuration of the light-blocking film, etc. illustrated in FIG. 3.
[FIG. 5] FIG. 5 is a schematic diagram for describing a smallest condensed-light diameter portion of an on-chip lens illustrated in FIG. 1.
[FIG. 6] FIG. 6 is a schematic cross-sectional diagram illustrating an example of a configuration of the light-blocking film, etc. illustrated in FIG. 1.
[FIG. 7] FIG. 7 is a schematic cross-sectional diagram illustrating a configuration of a main part of an imaging device according to a comparative example.
[FIG. 8] FIG. 8 is a schematic diagram illustrating a planar configuration of a light-blocking film, etc. illustrated in FIG. 7.
[FIG. 9] FIG. 9 is a schematic diagram for describing workings of the imaging device illustrated in FIG. 1.
[FIG. 10A] FIG. 10A is a diagram illustrating absorbed light and reflected light in the imaging device illustrated in FIG. 7.
[FIG. 10B] FIG. 10B is a diagram illustrating absorbed light and reflected light in the imaging device illustrated in FIG. 1.
[FIG. 11] FIG. 11 is a schematic cross-sectional diagram illustrating a configuration of a main part of an imaging device according to Modification Example 1.

[FIG. 12] FIG. 12 is a schematic cross-sectional diagram illustrating a configuration of a main part of an imaging device according to Modification Example 2.

[FIG. 13] FIG. 13 is a diagram illustrating an example of a configuration of the pixel circuit of the imaging device illustrated in FIG. 12.

[FIG. 14] FIG. 14 is a schematic diagram illustrating a planar configuration of a PD, etc. illustrated in FIG. 12.

[FIG. 15] FIG. 15 is a schematic diagram illustrating a planar configuration of a light-blocking film illustrated in FIG. 12.

[FIG. 16] FIG. 16 is a schematic planar diagram illustrating another example of a configuration of a pixel illustrated in FIG. 12.

[FIG. 17] FIG. 17 is a diagram illustrating an example of a circuit configuration of the pixel illustrated in FIG. 16.

[FIG. 18] FIG. 18 is a schematic planar diagram illustrating another example of the planar configuration of the pixel illustrated in FIG. 16.

[FIG. 19] FIG. 19 is a diagram illustrating an example of a circuit configuration of the pixel illustrated in FIG. 18.

[FIG. 20A] FIG. 20A is a schematic diagram illustrating an example of an overall configuration of the imaging device illustrated in FIG. 1 or the like.

[FIG. 20B] FIG. 20B is a schematic diagram illustrating another example (1) of the overall configuration of the imaging device illustrated in FIG. 20A.

[FIG. 20C] FIG. 20C is a schematic diagram illustrating another example (2) of the overall configuration of the imaging device illustrated in FIG. 20A.

[FIG. 21] FIG. 21 is a block diagram illustrating an example of a configuration of a distance measurement system to which the imaging device illustrated in FIG. 1 or the like is applied.

[FIG. 22] FIG. 22 is a block diagram (1) illustrating another example (1) of the distance measurement system illustrated in FIG. 21.

[FIG. 23] FIG. 23 is a block diagram (2) illustrating another example (2) of the distance measurement system illustrated in FIG. 21.

[FIG. 24] FIG. 24 is a block diagram (3) illustrating another example (3) of the distance measurement system illustrated in FIG. 21.

[FIG. 25A] FIG. 25A is a schematic planar diagram illustrating an example of a configuration of a front side of a portable electronic apparatus to which the imaging device illustrated in FIG. 1 or the like is applied.

[FIG. 25B] FIG. 25B is a schematic planar diagram illustrating an example of a configuration of a backside of the portable electronic apparatus illustrated in FIG. 25A.

[FIG. 26] FIG. 26 is a diagram illustrating examples of use of the imaging device illustrated in FIG. 1 or the like.

[FIG. 27] FIG. 27 is a block diagram depicting an example of a schematic configuration of an in-vivo information acquisition system.

[FIG. 28] FIG. 28 is a view depicting an example of a schematic configuration of an endoscopic surgery system.

[FIG. 29] FIG. 29 is a block diagram depicting an example of a functional configuration of a camera head and a camera control unit (CCU).

[FIG. 30] FIG. 30 is a block diagram depicting an example of schematic configuration of a vehicle control system.

[FIG. 31] FIG. 31 is a diagram of assistance in explaining an example of installation positions of an outside-vehicle information detecting section and an imaging section.

Modes for Carrying Out the Invention

In the following, an embodiment of the present disclosure will be described in detail with reference to the drawings. It is to be noted that the description is given in the following order.

    1. Embodiment (an imaging device in which a region larger than a half of each pixel is covered with a light-blocking film)
    2. Modification Example 1 (an example including a separation groove)
    3. Modification Example 2 (an example including two FDs (Floating Diffusions) in each pixel)
    3. Application Examples
    4. Examples of Practical Application

<Embodiment>

(Configuration of Imaging Device 1)

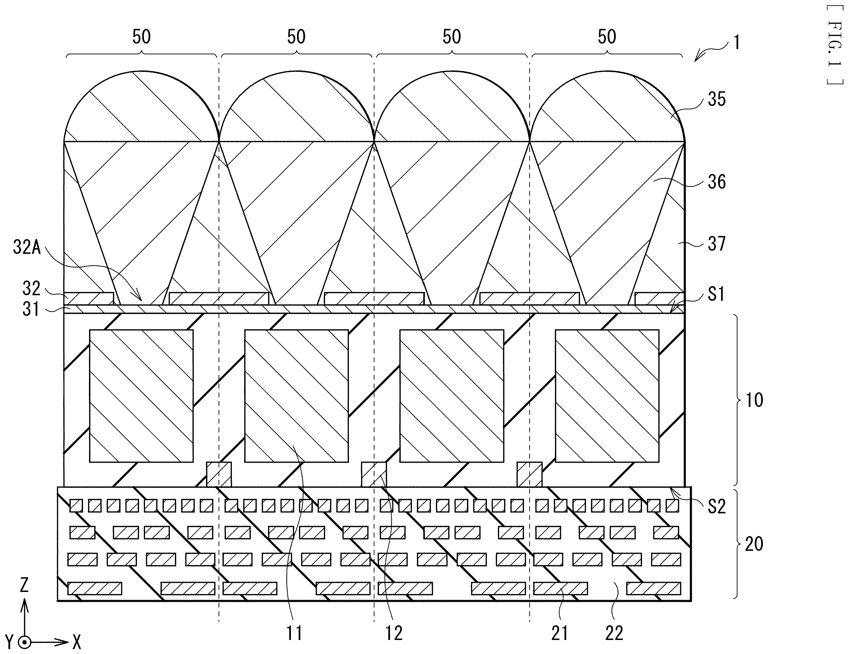

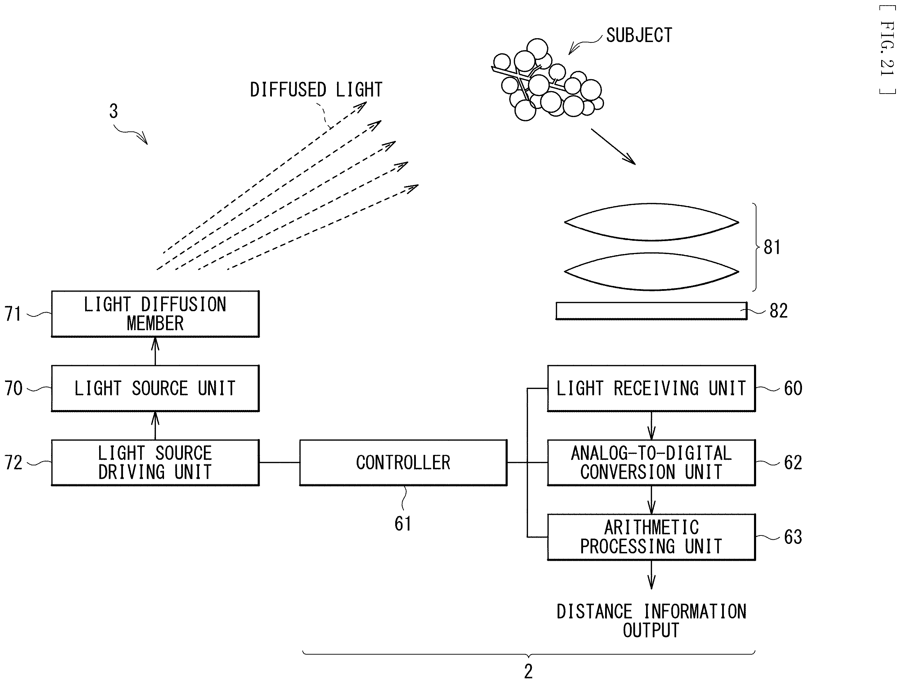

FIG. 1 schematically illustrates an example of a cross-sectional configuration of a main part of an imaging device (an imaging device 1) according to an embodiment of the present disclosure. The imaging device 1 is, for example, a backside illumination type CMOS (Complementary Metal Oxide Semiconductor) image sensor, and is applied to, for example, a distance measurement system (a distance measurement system 3 or the like in FIG. 21 to be described later). The imaging device 1 is configured to receive light having a wavelength in the near-infrared region, for example. The wavelength in the near-infrared region is, for example, a wavelength of about 800 nm to about 1100 nm.

The imaging device 1 includes a semiconductor substrate 10, a wiring layer 20, an antireflection film 31, a light-blocking film 32, a waveguide 36, a low refractive index material 37, and an on-chip lens 35. The semiconductor substrate 10 has a first surface S1 serving as a light receiving surface, and a second surface S2 opposed to the first surface S1. The wiring layer 20 is provided on side of the second surface S2 of the semiconductor substrate 10, and is stacked on the semiconductor substrate 10. The wiring layer 20 is a multilayer wiring layer, and includes a plurality of wiring lines 21 and an interlayer insulating film 22. On the first surface S1 of the semiconductor substrate 10, for example, the antireflection film 31, the light-blocking film 32, the waveguide 36, and the on-chip lens 35 are provided in this order from side of the semiconductor substrate 10.

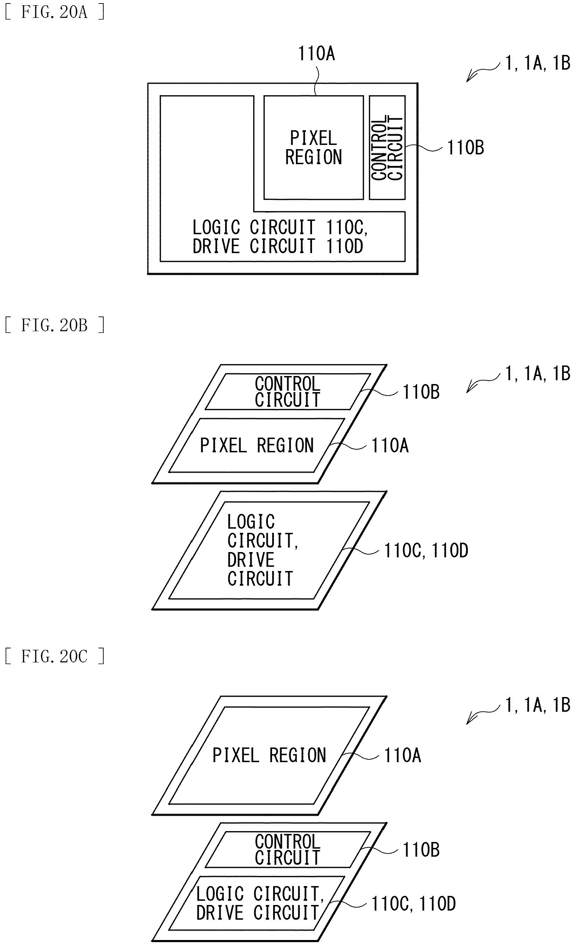

The imaging device 1 includes a plurality of pixels 50 in a pixel region (a pixel region 110A in FIGs. 20A to 20C to be described later). The plurality of pixels 50 is arranged in a matrix, for example. FIG. 1 illustrates four pixels 50 arranged side by side in one direction (an X direction).

In the following, each component of the imaging device 1 will be described.

The semiconductor substrate 10 is configured by p-type silicon (Si), for example. In the semiconductor substrate 10, a PD 11 and an FD 12 are provided for each pixel 50. Here, the PD 11 corresponds to a specific example of a photoelectric conversion unit of the present disclosure, and the FD 12 corresponds to a specific example of a first floating diffusion capacitance of the present disclosure.

The PD 11 is, for example, an n-type semiconductor region formed in a thickness direction (a Z direction) in the semiconductor substrate 10 (here, a Si substrate). The PD 11 has a pn junction with a p-type semiconductor region provided in the vicinity of the first surface S1 and the second surface S2 of the semiconductor substrate 10, and is thus a socalled pn junction type photodiode. The FD 12 is provided in the vicinity of the second surface S2 within the semiconductor substrate 10. This FD 12 is an n-type semiconductor region that is formed by implanting an n-type impurity at a high concentration into a p-well layer of the semiconductor substrate 10.

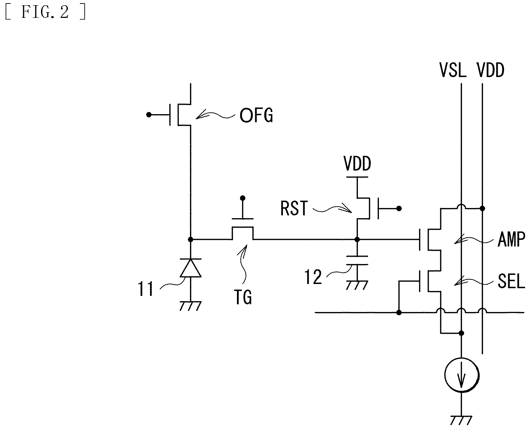

In the vicinity of the second surface S2 of the semiconductor substrate 10, for example, a transfer transistor, a reset transistor, an amplifier transistor, a selection transistor, a discharge transistor, and the like (a transfer transistor TG, a reset transistor RST, an amplifier transistor AMP, a selection transistor SEL, and a discharge transistor OFG in FIG. 2 to be described later) are provided. Such transistors are, for example, MOSEFTs (Metal Oxide Semiconductor Field Effect Transistors), and constitute a pixel circuit for each pixel 50.

FIG. 2 illustrates an example of a configuration of the pixel circuit.

The PD 11 includes an anode electrode coupled to a negative-side power supply (for example, a ground). The PD 11 photoelectrically converts received light (entering light) into optical charge having an amount of electric charge corresponding to a light amount of the received light, and accumulates the optical charge. A cathode electrode of the PD 11 is electrically coupled to a gate electrode of the amplifier transistor AMP via the transfer transistor TG. A node electrically connected to the gate electrode of the amplifier transistor AMP is the FD 12.

The transfer transistor TG is coupled between the cathode electrode of the PD 11 and the FD 12. A gate electrode of the transfer transistor TG is supplied with a transfer pulse via a transfer line. This brings the transfer transistor TG into conduction, causing the optical charge photoelectrically converted by the PD 11 to be transferred to the FD 12. The discharge transistor OFG is coupled to the cathode electrode of the PD 11 together with the transfer transistor TG.

The reset transistor RST includes a drain electrode coupled to a pixel power supply VDD, and a source electrode coupled to the FD 12. A gate electrode of the reset transistor RST is supplied with a reset pulse via a reset line. This brings the reset transistor RST into conduction, and the FD 12 is reset by discharging electric charge of the FD 12 to the pixel power supply VDD.

The amplifier transistor AMP includes the gate electrode coupled to the FD 12, and a drain electrode coupled to the pixel power supply VDD. Then, the amplifier transistor AMP outputs, as a reset signal, a potential of the FD 12 after being reset by the reset transistor RST. Furthermore, the amplifier transistor AMP outputs, as an optical accumulation signal, a potential of the FD 12 after signal electric charge is transferred by the transfer transistor TG.

The selection transistor SEL includes, for example, a drain electrode coupled to a source electrode of the amplifier transistor AMP, and a source electrode coupled to a vertical signal line VSL. A gate electrode of the selection transistor SEL is supplied with a selection pulse via a selection line. This brings the selection transistor SEL into conduction, and brings the pixel 50 into a selected state to cause the signal supplied from the amplifier transistor AMP to be outputted to the vertical signal line VSL.

In the example of FIG. 2, a circuit configuration is adopted in which the selection transistor SEL is coupled between the source electrode of the amplifier transistor AMP and the vertical signal line VSL. However, it is also possible to adopt a circuit configuration in which the selection transistor SEL is coupled between the pixel power supply VDD and the drain electrode of the amplifier transistor AMP

A circuit configuration of each pixel 50 is not limited to that of the above-described pixel configuration. For example, a pixel configuration may be adopted that includes a transistor serving as both of the amplifier transistor AMP and the selection transistor SEL or other pixel configurations, and the pixel circuit thereof may have any configuration. It is also possible for the transistors other than the transfer transistor TG to be shared among the plurality of pixels 50.

The plurality of wiring lines 21 included in the wiring layer 20 constitutes, for example, the pixel circuit and the vertical signal line VSL or the like as well as the gate electrodes of the transistors described above. The wiring lines 21 are formed with the pixel 50 as a unit of repetition, for example. The interlayer insulating film 22 is configured by, for example, an SiO (silicon oxide) film or the like.

The antireflection film 31 covers the first surface S1 of the semiconductor substrate 10. The antireflection film 31 is provided over the entire surface of the pixel region, for example. The antireflection film 31 is configured by, for example, silicon nitride (SiN), aluminum oxide ($Al_2O_3$), silicon oxide ($SiO_2$), hafnium oxide ($HfO_2$), tantalum oxide ($Ta_2O_5$), or the like.

The light-blocking film 32 provided on the antireflection film 31 has a characteristic of disallowing light having a wavelength in the near-infrared region to pass therethrough. Providing such a light-blocking film 32 makes it possible to suppress color mixture resulting from crosstalk of obliquely entering light between adjacent pixels 50. The light-blocking film 32 has an opening 32A at a position opposed to the PD 11 of each pixel 50. Light enters the PD 11 through the opening 32A of the light-blocking film 32.

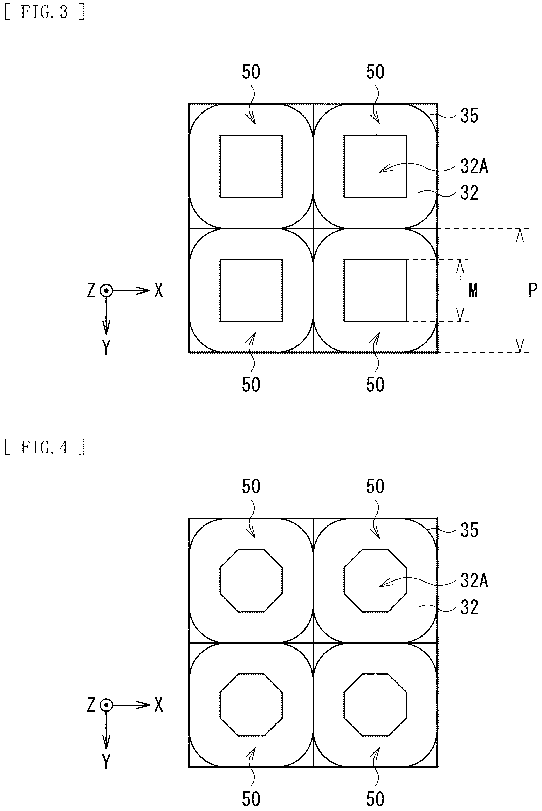

FIG. 3 illustrates an example of a planar (an XY-planar) configuration of the light-blocking film 32 and the on-chip lens 35. In FIG. 3, four pixels 50 arranged in two rows × two columns are illustrated. Each pixel 50 has, for example, a substantially square planar shape having a dimension of P at each side. The opening 32A of the light-blocking film 32 is provided at a middle part of each pixel 50. The opening 32A has, for example, a substantially square planar shape having a dimension of M at each side. In the present embodiment, the light-blocking film 32 having the opening 32A satisfies Equation (1) below.

$$B < A \ ..... \ (1)$$

where B is an area of the opening 32A in each pixel 50, and A is an area of the first surface S1 of the semiconductor substrate 10 covered with the light-blocking film 32 in each pixel 50.

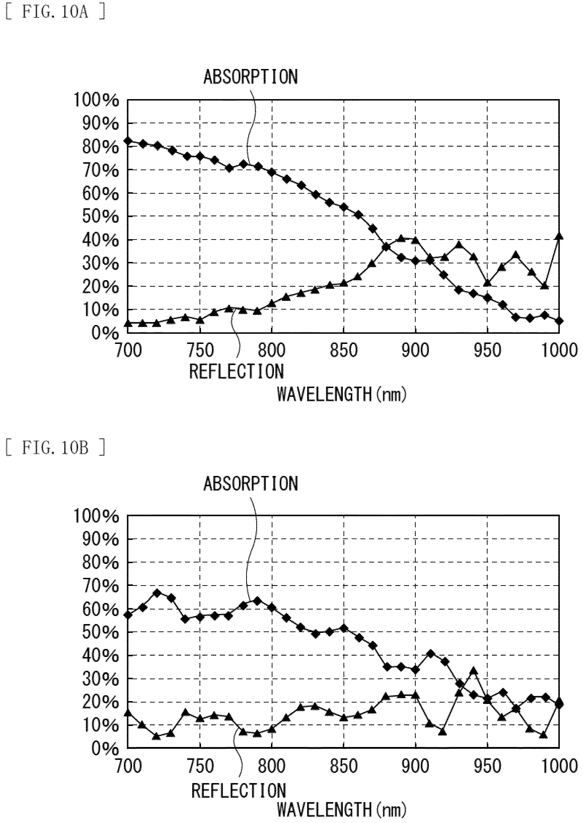

For example, when the pixel 50 and the opening 32A have the planar shape described above, B and A are determined as follows: $B = M^2$; and $A = P^2 - M^2$. For example, when P is 10 $\mu$m, Equation (1) is satisfied if M is 7 $\mu$m. In this case, a proportion of the area A in the area ($P^2$) of each pixel 50 is 51%. While the details will be described later, owing to the light-blocking film 32 satisfying Equation (1) as described above, light reflected at an interface between the semiconductor substrate 10 (the second surface S2) and the wiring layer 20 or at the wiring layer 20 (reflected light RL in FIG. 10 to be described later) is not easily radiated from the first surface S1 of the semiconductor substrate 10 to the outside of the semiconductor substrate 10 (toward the on-chip lens 35).

It is preferable that the light-blocking film 32 further satisfy Expression (2) below:

$$A \geq 0.75 \times (A + B) \ ..... \ (2).$$

By making the light-blocking film 32 satisfy Expression (2), that is, by making the proportion of the area A in the area of each pixel 50 (i.e., the sum of the area A and the area B) be 75% or more, it is possible to more effectively suppress the emission of the reflected light RL to the outside of the semiconductor substrate 10. For example, when P is 10 $\mu$m, the proportion of the area A in the area of each pixel 50 is 75% ($A = 0.75 \times (A + B)$) if M is 5 $\mu$m.

FIG. 4 illustrates another example of the planar configuration of the light-blocking film 32 and the on-chip lens 35. The planar shape of the opening 32A of the light-blocking film 32 may be, for example, a polygonal shape such as a substantially octagonal shape. Although illustration is omitted, the opening 32A may have a substantially elliptical planar shape, for example.

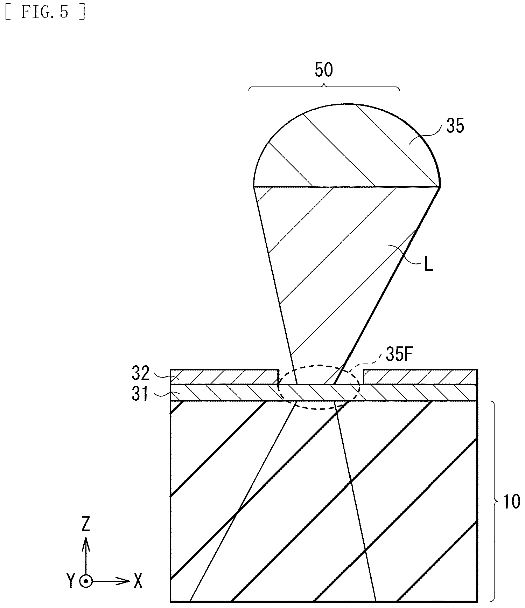

FIG. 5 illustrates a relationship between light condensed by the on-chip lens 35 (light L) and the light-blocking film 32. In the stacking direction (Z-axis direction), the light-blocking film 32 is preferably disposed at a smallest condensed-light diameter portion 35F of the on-chip lens 35. The smallest condensed-light diameter portion 35F is a portion where a spot size of the light condensed by the on-chip lens 35 is the smallest in the Z-axis direction, and corresponds to the vicinity of a beam waist in Gaussian beam optics. Disposing the light-blocking film 32 at the smallest condensed-light diameter portion 35F as described above makes it possible to suppress a reduction in sensitivity even if the opening 32A is made smaller.

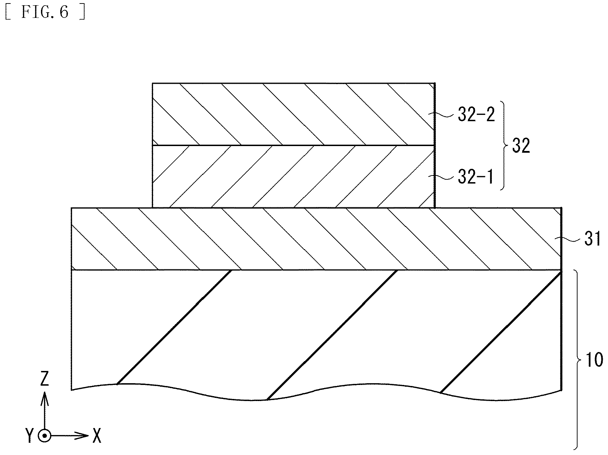

FIG. 6 illustrates an example of the cross-sectional configuration of the light-blocking film 32 together with the semiconductor substrate 10 and the antireflection film 31. The light-blocking film 32 has a stacked structure including, for example, a first light-blocking film 32-1 and a second light-blocking film 32-2 from side of the semiconductor substrate 10 (or the antireflection film 31). The first light-blocking film 32-1 has, for example, a reflective property for light having a wavelength in the near-infrared region. Such a first light-blocking film 32-1 includes, for example, a conductor metal such as aluminum (Al) or copper (Cu) as a main component. The second light-blocking film 32-2 stacked on the first light-blocking film 32-1 has, for example, both of a reflective property and an absorptive property for light having a wavelength in the near-infrared region. Such a second light-blocking film 32-2 includes, for example, tungsten (W) or the like as a main component. The second light-blocking film 32-2 may mainly have an absorptive property for light having a wavelength in the near-infrared region. Such a second light-blocking film 32-3 includes, for example, a carbonized material such as carbon black, or titanium black or the like as a main component. At least owing to the first light-blocking film 32-1 having the reflective property for light of a wavelength in the near-infrared region, light traveling from the inside of the semiconductor substrate 10 toward the outside of the semiconductor substrate 10 via the first surface S1 (for example, the reflected light RL in FIG. 10 to be described later) is reflected and travels toward the inside of the semiconductor substrate 10 again. Supposing the first light-blocking film 32-1 has an absorptive property for light having a wavelength in the near-infrared region, such reflected light RL does not return to the inside of the semiconductor substrate 10 (more specifically, PD11), and therefore sensitivity can be reduced. Thus, owing to the first light-blocking film 32-1 having the reflective property for light having a wavelength in the near-infrared region, it is possible to suppress a reduction in sensitivity. The light-blocking film 32 may be configured by a single film, or may be configured by a stacked film including three or more layers.

The waveguide 36 is provided to extend from the on-chip lens 35 to the opening 32A of the light-blocking film 32, for example. The waveguide 36 is provided, for example, between the on-chip lens 35 and the first surface S1 of the semiconductor substrate 10 for each pixel 50. The waveguide 36 is for guiding the light L condensed by the on-chip lens 35 to the PD 11 (the semiconductor substrate 10). Providing such a waveguide 36 makes it possible to improve the sensitivity.

The waveguide 36 is formed to be sandwiched by the low refractive index material 37, for example. In other words, the waveguide 36 is surrounded by the low refractive index material 37. The material that configures the waveguide 36 has a refractive index higher than a refractive index of the low refractive index material 37. For example, the waveguide 36 is configured by silicon nitride (SiN), and the low refractive index material 37 is configured by silicon oxide (SiO).

The on-chip lens 35 is provided on a light entrance side of the light-blocking film 32. In other words, the on-chip lens 35 covers the first surface S1 of the semiconductor substrate 10 with the light-blocking film 32 interposed therebetween. The on-chip lens 35 is provided for each pixel 50. Light entering the on-chip lens 35 is to be condensed onto the PD 11 for each pixel 50. A lens system of the on-chip lens 35 is set to a value corresponding to the size of the pixel 50. Examples of the material of the on-chip lens 35 include an organic material, a silicon oxide film ($SiO_2$), and the like.

(Operation of Imaging Device 1)

In such an imaging device 1, signal electric charge (for example, electron) is acquired in the following manner, for example. When light passes through the on-chip lens 35, the waveguide 36, etc. and enters the first surface S1 of the semiconductor substrate 10, the light (light having a wavelength in the near-infrared region) is detected (absorbed) at the PD 11 of each pixel 50 and photoelectrically converted. Of the electron-hole pairs generated in the PD 11, for example, the electron moves to the FD 12 and is accumulated, and the hole moves to the p-type region and is discharged. The electron accumulated in the FD 12 is outputted to the vertical signal line VSL as an optical accumulation signal for each pixel 50.

(Workings and Effects of Imaging Device 1)

In the present embodiment, the opening 32A of the light-blocking film 32 satisfies Expression (1). That is, in each pixel 50, the area of the region covered with the light-blocking film 32 (the area A) is greater than the area of the opening 32A of the light-blocking film 32 (the area B). As a result, light reflected at the interface between the semiconductor substrate 10 and the wiring layer 20 or in the wiring layer 20 (the reflected light RL in FIG. 10 to be described later) enters the light-blocking film 32, and is thus not easily radiated from the first surface S1 of the semiconductor substrate 10 to the outside of the semiconductor substrate 10. Such workings and effects will be described below by using a comparative example.

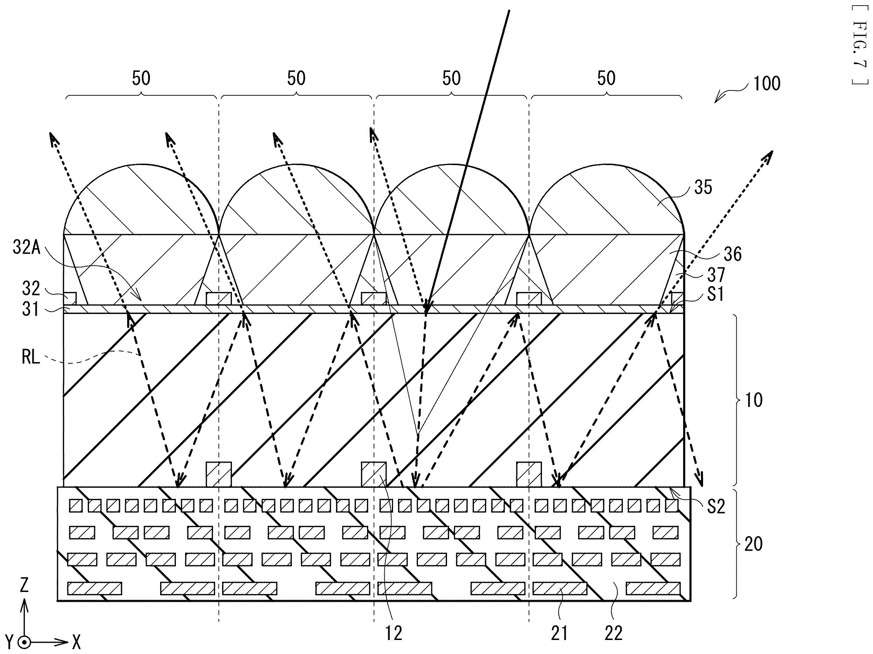

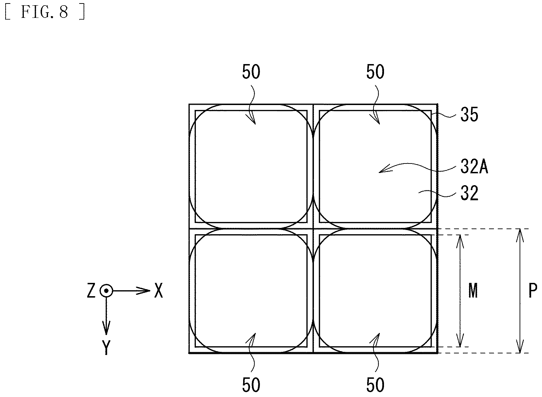

FIGs. 7 and 8 illustrate a schematic configuration of a main part of an imaging device (an imaging device 100) according to a comparative example. FIG. 7 illustrates a cross-sectional configuration of the imaging device 100, and corresponds to FIG. 1 illustrating the imaging device 1. FIG. 8 illustrates a planar configuration of the imaging device 100, and corresponds to FIG. 3 illustrating the imaging device 1. In the imaging device 100, as in the imaging device 1, the first surface S1 of the semiconductor substrate 10 serves as the light entrance surface, and the wiring layer 20 is stacked on the second surface S2. That is, the imaging device 100 is a backside illumination type imaging device.

In the backside illumination type imaging device 100, reflected light RL occurs more easily than in a frontside illumination type imaging device. One reason for this is that the imaging device 100 has the interface between the semiconductor substrate 10 (the second surface S2) and the wiring layer 20 and an interface resulting from the wiring line 21 in the wiring layer 20 (an interface between the wiring line 21 and the interlayer insulating film 22) on side of the second surface S2 of the semiconductor substrate 10.

The light L condensed by the on-chip lens 35 (including light having a wavelength in the near-infrared region) enters the inside of the semiconductor substrate 10 from the first surface S1. For example, the semiconductor substrate 10 configured by silicon (Si) is lower in sensitivity (or lower in quantum efficiency) to light having a wavelength in the near-infrared region than to light having a wavelength in the visible region. In other words, the semiconductor substrate 10 is in a semi-transparent state to light having a wavelength in the near-infrared region, and therefore the light L enters deep in the thickness direction of the semiconductor substrate 10. This light L is reflected at the interface between the semiconductor substrate 10 and the wiring layer 20 or in the wiring layer 20, and becomes the reflected light RL. In the front-side illumination type imaging device, such an interface is not present on side of the second surface of the semiconductor substrate. Therefore, in the front-side illumination type imaging device, light that enters the inside of the semiconductor substrate from the first surface is not easily reflected on side of the second surface of the semiconductor substrate.

In the imaging device 100, the reflected light RL occurring on side of the second surface S2 of the semiconductor substrate 10 is radiated from the first surface S1 to the outside of the semiconductor substrate 10 through the opening 32A of the light-blocking film 32. In each pixel 50 of the imaging device 100, the area of the region covered with the light-blocking film 32 is smaller than the area of the opening 32A of the light-blocking film 32. Accordingly, much reflected light RL is emitted from the first surface S1 to the outside of the semiconductor substrate 10 through the opening 32A. The reflected light RL emitted to the outside of the semiconductor substrate 10 greatly affects imaging information. For example, the reflected light RL emitted to the outside of the semiconductor substrate 10 can cause flare, ghosting, and the like. Further, when the imaging device 1 is applied to, for example, a distance measurement system, multiple reflections of the reflected light RL can occur between lenses or between a lens and the semiconductor substrate 10 to cause a distance measurement error.

In contrast to such an imaging device 100, in each pixel 50 of the imaging device 1 of the present embodiment, the area of the region covered with the light-blocking film 32 (the area A) is greater than the area of the opening 32A of the light-blocking film (the area B). Accordingly, even if the reflected light RL occurs on side of the second surface S2 of the semiconductor substrate 10, the reflected light RL is not easily emitted from the first surface S1 to the outside of the semiconductor substrate 10 in contrast to the imaging device 100.

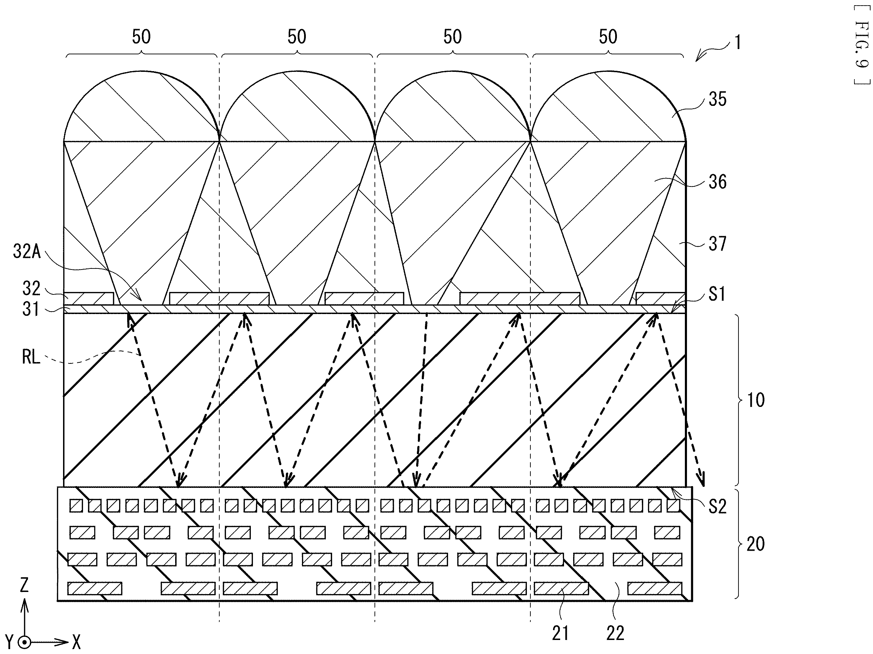

FIG. 9 illustrates the reflected light RL occurring in the imaging device 1. In the imaging device 1, the reflected light RL traveling from side of the second surface S2 of the semiconductor substrate 10 to side of the first surface S1 enters the light-blocking film 32 and, for example, travels from the light-blocking film 32 to the inside of the semiconductor substrate 10 again. Thus, the imaging device 1 is configured not to allow the reflected light RL to be easily radiated to the outside of the semiconductor substrate 10. This makes it possible to reduce an influence of the reflected light RL on the imaging information and to suppress the occurrence of flare, ghosting, and the like. Further, when the imaging device 1 is applied to a distance measurement system, for example, it is possible to reduce the distance measurement error.

FIGs. 10A and 10B illustrate the results of determining a relationship between reflected light (the reflected light RL in FIGs. 7 and 8) radiated from the first surface S1 of the semiconductor substrate 10 to the outside of the semiconductor substrate 10 and light absorbed by the semiconductor substrate 10, using an optical simulation. FIG. 10A illustrates the result on the imaging device 100, and FIG. 10B illustrates the result on the imaging device 1. The results on the imaging devices 1 and 100 are compared for a wavelength of, for example, 950 nm. In this case, for the imaging device 100, the light absorbed by the semiconductor substrate 10 accounts for 16%, and the reflected light radiated to the outside of the semiconductor substrate 10 accounts for 22%; whereas for the imaging device 1, the light absorbed by the semiconductor substrate 10 accounts for 22%, and the reflected light radiated to the outside of the semiconductor substrate 10 accounts for 20%. That is, for the imaging device 1, improvements in both of absorption and reflection have been confirmed relative to the imaging device 100. From the results of this optical simulation also, it is seen that the opening 32A of the light-blocking film 32 satisfying Expression (1) makes it possible to reduce the reflected light RL to be emitted to the outside of the semiconductor substrate 10 and to allow light of a wavelength in the near-infrared region to be absorbed by the semiconductor substrate 10 with higher efficiency.

Furthermore, with the imaging device 1, disposing the light-blocking film 32 at the smallest condensed-light diameter portion 35F of the on-chip lens 35 suppresses a reduction in sensitivity even if the opening 32A is made smaller.

Further, the imaging device 1 is provided with the waveguide 36, and therefore makes it possible to improve sensitivity compared with the imaging device 1.

As described above, according to the imaging device 1 of the present embodiment, because the opening 32A of the light-blocking film 32 satisfies Expression (1), it is possible to hinder light (the reflected light RL) reflected at the interface between the semiconductor substrate 10 and the wiring layer 20 or in the wiring layer 20 from being emitted to the outside of the semiconductor substrate 10. This makes it possible to reduce an influence of the reflected light RL inside the imaging device 1 on the imaging signal.

Further, by disposing the light-blocking film 32 at the smallest condensed-light diameter portion 35F of the on-chip lens 35, it is possible to suppress a reduction in sensitivity.

Further, the imaging device 1 is provided with the waveguide 36, and therefore makes it possible to improve sensitivity compared with the imaging device 1.

In the following, modification examples of the foregoing embodiment will be described. In the following description, the same components as those of the embodiment described above are denoted with the same reference numerals, and the description thereof will be omitted as appropriate.

<Modification Example 1>

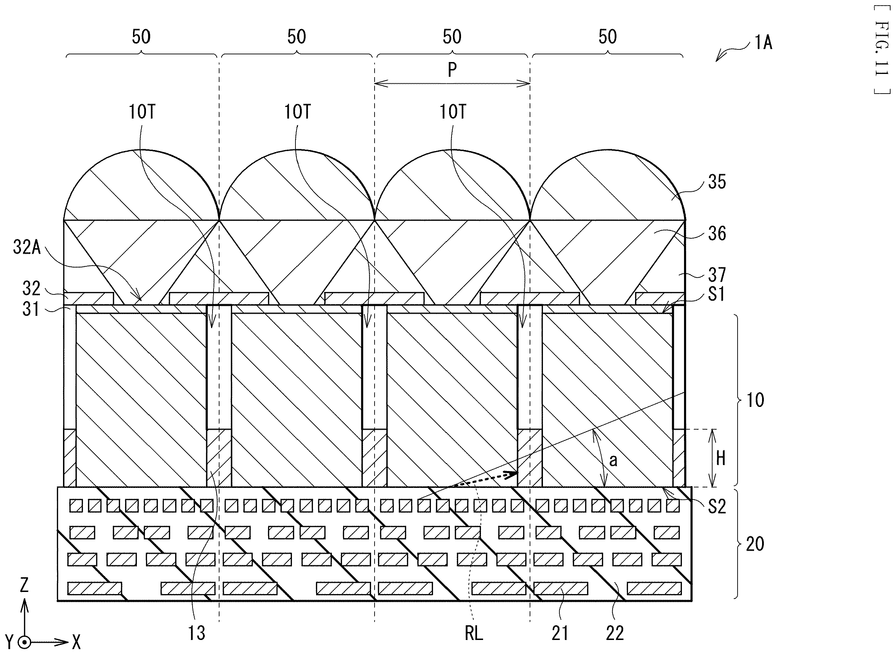

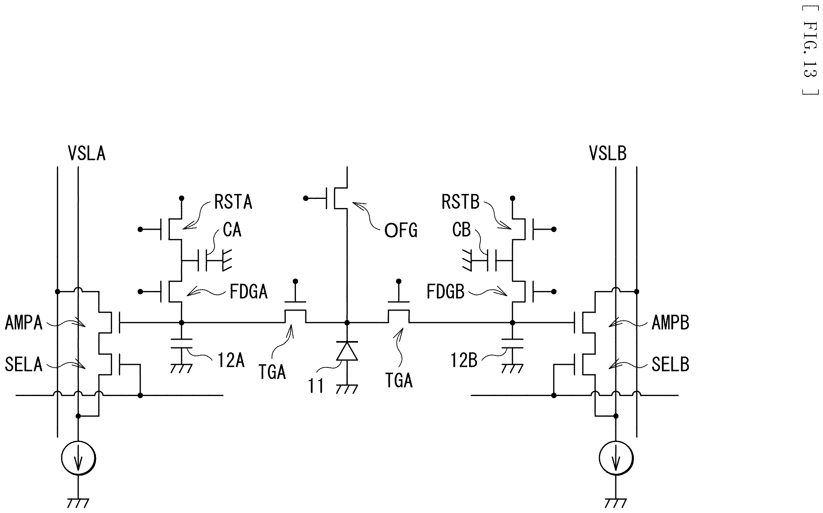

FIG. 11 illustrates a schematic cross-sectional configuration of a main part of an imaging device (an imaging device 1A) according to Modification Example 1 of the foregoing embodiment. FIG. 11 corresponds to FIG. 1 illustrating the imaging device 1. In the imaging device 1A, the semiconductor substrate 10 is provided with a separation groove 10T separating adjacent pixels 50 from each other. Except for this point, the imaging device 1A according to Modification Example 1 has a configuration similar to that of the imaging device 1, and workings and effects thereof are also similar to those of the imaging device 1. It is to be noted that in FIG. 13, illustrations of the PD 11 and the FD 12 illustrated in FIG. 1 are omitted.

The separation groove 10T is provided to penetrate the semiconductor substrate 10 in the thickness direction from the first surface S1 to the second surface S2, for example. The separation groove 10T has, for example, a grid-like planar shape, and is disposed to surround each pixel 50. For example, an insulating material such as silicon oxide (SiO) is embedded in the separation groove 10T. By providing such a separation groove 10A, it is possible to suppress the occurrence of crosstalk between the plurality of pixel 50.

For example, an embedded light-blocking section 13 is provided in the separation groove 10T. The embedded light-blocking section 13 is configured by a light-blocking material, and is provided to extend over a portion of the separation groove 10T in the depth direction (the Z-axis direction) from the second surface S2. Examples of the light-blocking material that configures the embedded light-blocking section 13 include metal materials such as tungsten (W), aluminum (Al), and copper (Cu). It is preferable that a dimension H of the embedded light-blocking section 13 in the depth direction satisfy Expression (3) below:

$$H > P/2 \times \tan(a) \ ..... \ (3)$$

where P is a dimension of a side of each pixel 50, and a is a critical angle with respect to the separation groove 10T described above.
a is represented by Equation (4) below:
[Math. 1]

$$\sin(a) = n_1/n_2 \ ..... \ (4)$$

where $n_1$ is a refractive index of the separation groove 10T, $n_2$ is a refractive index of the semiconductor substrate 10.

For example, when silicon oxide (SiO) is embedded in the separation groove 10T and the semiconductor substrate 10 is configured by crystalline silicon (Si), $n_1$ is approximately 1.45 and $n_2$ is approximately 3.7; and therefore the critical angle a with respect to the separation groove 10T is approximately 23°.

With the dimension H of the embedded light-blocking section 13 in the depth direction satisfying Expression (3) above, the reflected light RL entering the separation groove 10T at an angle smaller than the critical angle a is hindered from entering adjacent pixels 50. Accordingly, it is possible to suppress the occurrence of crosstalk between pixels 50 more effectively.

In the imaging device 1A of the present modification example also, as in the imaging device 1 of the foregoing embodiment, the opening 32A of the light-blocking film 32 satisfies Expression (1). Accordingly, the light reflected at the interface between the semiconductor substrate 10 and the wiring layer 20 or in the wiring layer 20 enters the light-blocking film 32, and is thus not easily radiated from the first surface S of the semiconductor substrate 10 to the outside of the semiconductor substrate 10. Further, the provision of the separation groove 10T separating the pixels 50 from each other suppresses the occurrence of crosstalk between the pixels 50 more effectively. As a result, it is possible to obtain an infrared image or a distance measurement image at a high spatial resolution, for example. Furthermore, by providing the embedded light-blocking section 13 in the separation groove 10T to allow the dimension H in the depth direction to satisfy Expression (3) above, it is possible to suppress the occurrence of crosstalk even more effectively.

<Modification Example 2>

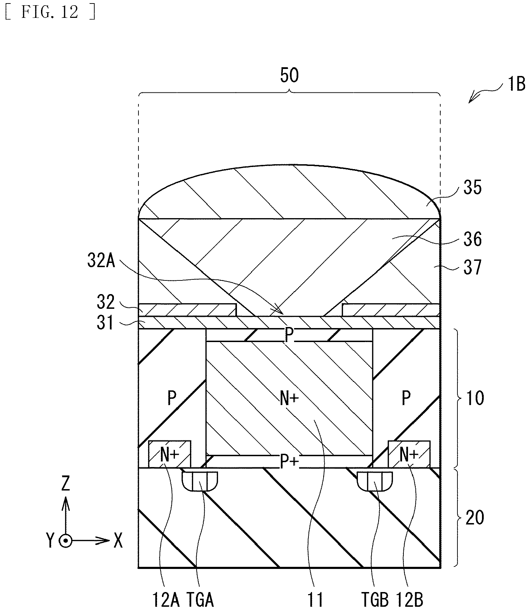

FIG. 12 illustrates a schematic cross-sectional configuration of a main part of an imaging device (an imaging device 1B) according to Modification Example 2 of the foregoing embodiment. FIG. 12 illustrates a configuration of one pixel 50. The imaging device 1B is provided with one PD 11, two transfer transistors (transfer transistors TGA and TGB), and two FDs (FDs 12A and 12B) for each pixel 50. The imaging device 1B is suitably used in a distance measurement system that utilizes an indirect ToF (Time of Flight) scheme. In the distance measurement system utilizing the indirect ToF scheme, active light that is projected from a light source at a certain phase and is reflected by a target upon impinging thereon is received by the imaging device 1B. In the imaging device 1B, this light is to be distributed between a plurality of regions (the FDs 12A and 12B). Except for this point, the imaging device 1B according to Modification Example 2 has a configuration similar to that of the imaging device 1, and workings and effects thereof are also similar to those of the imaging device 1.

FIG. 13 illustrates an example of the circuit configuration of each pixel 50. The cathode electrode of the PD 11 is coupled to the transfer transistor TGA and the transfer transistor TGB, and to the discharge transistor OFG. The transfer transistor TGA is electrically coupled to a gate electrode of an amplifier transistor AMPA. A node electrically connected to the gate electrode of the amplifier transistor AMPA is the FD 12A. A drain electrode of a selection transistor SELA is coupled to a source electrode of the amplifier transistor AMPA. When the selection transistor SELA is brought into conduction, a signal supplied from the amplifier transistor AMPA is outputted to a vertical signal line VSLA. A capacitance switching transistor FDGA and an additional capacitance CA are coupled between the FD 12A and a reset transistor RSTA.

The transfer transistor TGB is electrically coupled to a gate electrode of an amplifier transistor AMPB. A node electrically connected to the gate electrode of the amplifier transistor AMPB is the FD 12B. A drain electrode of a selection transistor SELB is coupled to a source electrode of the amplifier transistor AMPB. When the selection transistor SELB is brought into conduction, a signal supplied from the amplifier transistor AMPB is outputted to a vertical signal line VSLB. A capacitance switching transistor FDGB and an additional capacitance CB are coupled between the FD 12B and a reset transistor RSTB. Here, the transfer transistors TGA and TGB correspond to respective specific examples of a first transfer transistor and a second transfer transistor of the present disclosure, and the FDs 12A and 12B correspond to respective specific examples of the first floating diffusion capacitance and a second floating diffusion capacitance of the present disclosure.

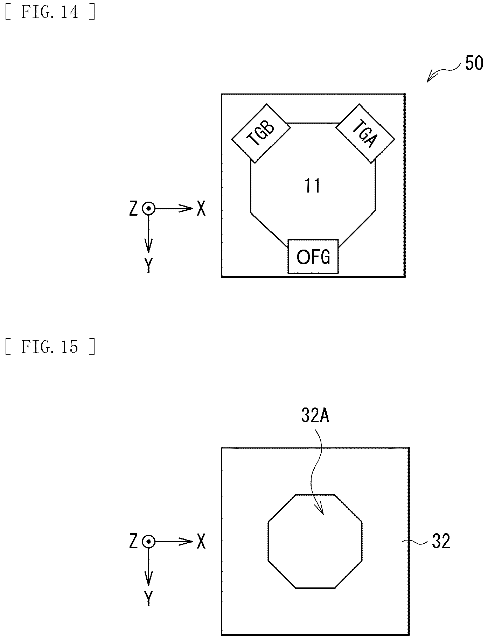

FIG. 14 illustrates an example of a planar (the XY-planar) configuration of the PD 11, the transfer transistors TGA and TGB, and the discharge transistor OFG. The PD 11 has, for example, a substantially octagonal planar shape, and the transfer transistors TGA and TGB and the discharge transistor OFG are disposed near the edge of the PD 11, for example.

FIG. 15 illustrates an example of a planar configuration of the light-blocking film 32. The opening 32A of the light-blocking film 32 has, for example, a substantially octagonal planar shape in correspondence with the planar shape of the PD 11.

The pixel 50 may have a CAPD (Current Assisted Photonic Demodulator) pixel structure, for example. Such a pixel 50 has a voltage application section in the semiconductor substrate 10 to cause a voltage to be directly applied to the semiconductor substrate 10. As a result, a current is generated in the semiconductor substrate 10, and it is possible to modulate an extensive region in the semiconductor substrate 10 at a high speed (see, for example, Japanese Unexamined Patent Application Publication No. 2018-117117).

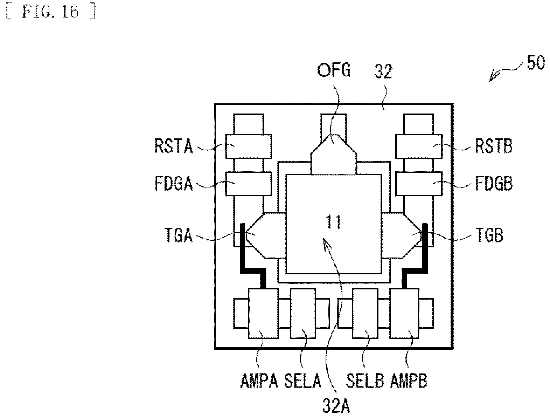

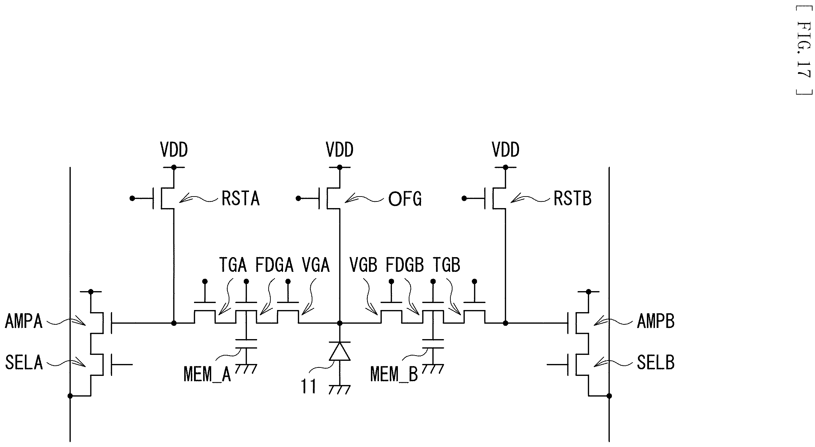

FIGs. 16 and 17 illustrate another example of the configuration of the pixel 50 of the imaging device 1B. FIG. 16 illustrates a planar configuration of the pixel 50, and FIG. 17 illustrates a circuit configuration of the pixel 50. FIGs. 12 and 13 described above illustrate a case where the signal electric charge is accumulated in the FDs 12A and 12B; however, the signal electric charge may be accumulated in an MEM (Memory, an electric charge accumulation section), as illustrated in FIGs. 16 and 17. In this case, for example, each pixel 50 is provided with two MEMs (MEM-A and MEM-B), and transfer transistors VGA and VGB for transferring the signal electric charge from the PD 11 to the MEM-A and the MEM-B.

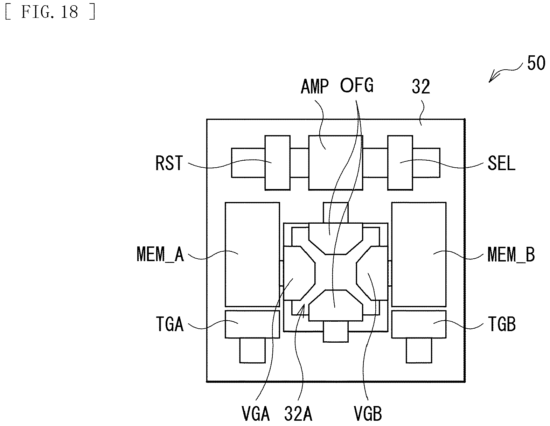

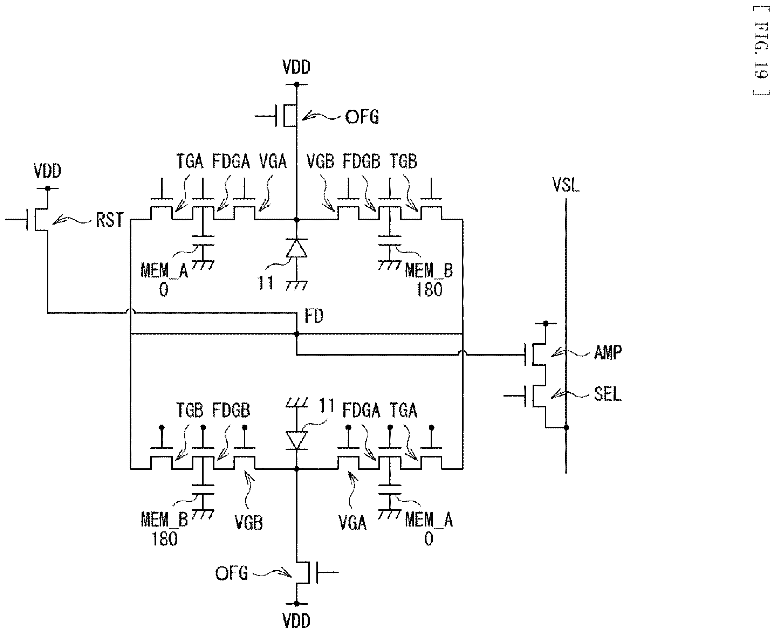

FIG. 18 illustrates another example of the planar configuration of the pixel 50 illustrated in FIG. 16, and FIG. 19 illustrates another example of the circuit configuration of the pixel 50 illustrated in FIG. 17. As illustrated, an FD (FDA and FDB in FIG. 17) to which the signal electric charge is transmitted from each of the transfer transistors TGA and TGB, may be shared.

In the imaging device 1B also, as in the imaging device 1 of the foregoing embodiment, the opening 32A of the light-blocking film 32 satisfies Expression (1). Accordingly, the light reflected at the interface between the semiconductor substrate 10 and the wiring layer 20 or in the wiring layer 20 enters the light-blocking film 32, and is thus not easily radiated from the first surface S1 of the semiconductor substrate 10 to the outside of the semiconductor substrate 10.

<Overall Configuration of Imaging Device 1, etc.>

FIGs. 20A, 20B, and 20C are schematic diagrams illustrating examples of overall configurations of the imaging devices 1, 1A, and 1B illustrated in FIG. 1, etc. The imaging devices 1, 1A, and 1B include, for example, a pixel region 110A in which the plurality of pixels 50 is provided, a control circuit 110B, a logic circuit 110C, and a drive circuit 110D. The pixel region 110A, the control circuit 110B, the logic circuit 110C, and the drive circuit 110D may be configured as a single chip as illustrated in FIG. 20A, or may be configured as a plurality of chips, as illustrated in FIG. 20B and FIG. 20C.

<Application Examples>

FIG. 21 is a block diagram illustrating an example of a configuration of a distance measurement system 3 to which the imaging device 1, 1A, or 1B is applied. The distance measurement system 3 includes, for example, a light source unit 70, a light diffusion member 71, a light source driving unit 72, and an imaging system 2. The imaging system 2 includes, for example, a lens group 81, a bandpass filter 82, a light receiving unit 60, a controller 61, an analog-to-digital conversion unit 62, and an arithmetic processing unit 63. The light receiving unit 60 is configured by the pixel region 110A of the foregoing embodiment or the like.

The light source unit 70 projects infrared light having a wavelength in a range of, for example, about 700 nm to about 1100 nm. The light source unit 70 includes a laser light source, an LED (Light Emitting Diode) light source, or the like. A center wavelength of the light source unit 70 is, for example, 850 nm, 905 nm, 940 nm, or the like. The light source unit 70 is driven by the light source driving unit 72 that is controlled by the controller 61.

It suffices that the wavelength of the infrared light to be projected by the light source unit 70 is appropriately selected depending on the intended use and configuration of the distance measuring system. For example, a value such as approximately 850 nanometers, approximately 905 nanometers, or approximately 940 nanometers is selectable as the center wavelength.

The lens group 81 and the bandpass filter 82 are provided on a light receiving surface side of the light receiving unit 60. Light condensed by the lens group 81 enters the bandpass filter 82. The bandpass filter 82 is configured to be selectively transparent to infrared light in a predetermined wavelength range.

A signal obtained at the light receiving unit 60 is digitized by the analog-to-digital conversion unit 62 and transmitted to the arithmetic processing unit 63. The arithmetic processing unit 63 is configured to determine distance information of a target on the basis of data from the light receiving unit 60. The series of operations is controlled by the controller 61, for example.

The light receiving unit 60, the analog-to-digital conversion unit 62, the arithmetic processing unit 63, the controller 61, and the light source driving unit 72 are formed on a semiconductor substrate including silicon, for example.

The arithmetic processing unit 63 may be one that obtains distance information on the basis of a pattern of reflected light from the target. That is, the distance measurement system 3 may be a distance measurement system of the indirect Time of Flight scheme. In this case, for example, infrared light is projected onto the target in a predetermined pattern. Alternatively, the arithmetic processing unit 63 may be one that obtains distance information on the basis of the time of flight of the reflected light from the target. The time of flight of the light is measured, for example, by a TDC (Time Digital Converter). That is, the distance measurement system 3 may be a distance measurement system of a direct Time of Flight scheme.

In the distance measurement system 3 illustrated in FIG. 21, the light diffusion member 71 is disposed in front of the light source unit 70, and diffused light is projected from the light diffusion member 71. The light source unit 70 is modulated at a frequency of, for example, several tens of kHz to several hundreds of MHz. According to the distance measurement system 3, it is possible to obtain the distance information by detecting a reflected light component in synchronization with the modulation of the light source unit 70.

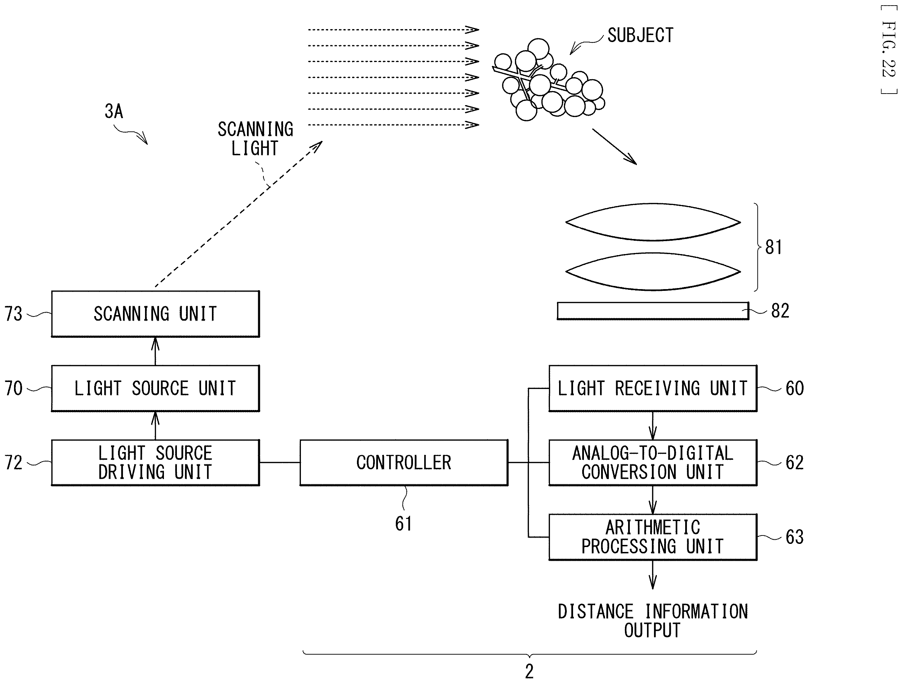

FIG. 22 is a block diagram illustrating an example of a configuration of a distance measurement system 3A. The imaging device 1, 1A, or 1B may be applied to such a distance measurement system 3A. Like the distance measurement system 3, the distance measurement system 3A also obtains distance information on the basis of the time of flight of the reflected light. In the distance measurement system 3A, light from the light source unit 70 is scanned by a scanning unit 73. It is possible to obtain the distance information by detecting the reflected light component in synchronization with the scanning.

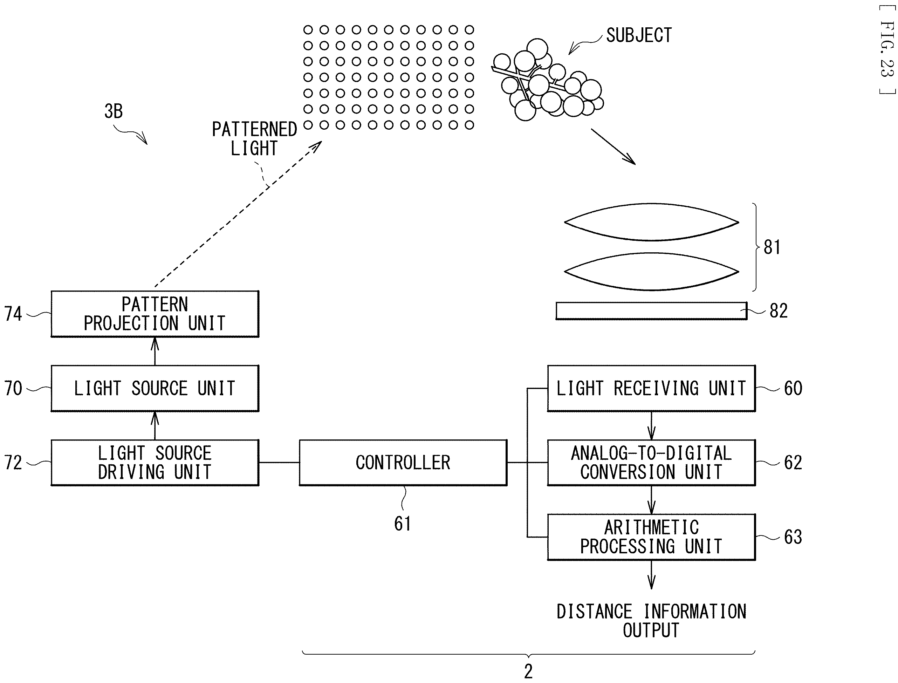

FIG. 23 is a block diagram illustrating an example of a configuration of a distance measurement system 3B. The imaging device 1, 1A, or 1B may be applied to such a distance measurement system 3B. In the distance measurement system 3B, infrared light is projected onto the target in a predetermined pattern. The arithmetic processing unit 63 of the distance measurement system 3B is able to obtain the distance information on the basis of the pattern of the reflected light from the target. In the distance measurement system 3B, the light from the light source unit 70 is made into a predetermined pattern that is spatially nonuniform, and is projected onto the target. It is possible to obtain the distance information (or parallax information) by detecting spatial distribution information of an illuminance pattern or distortion of a pattern image on the target.

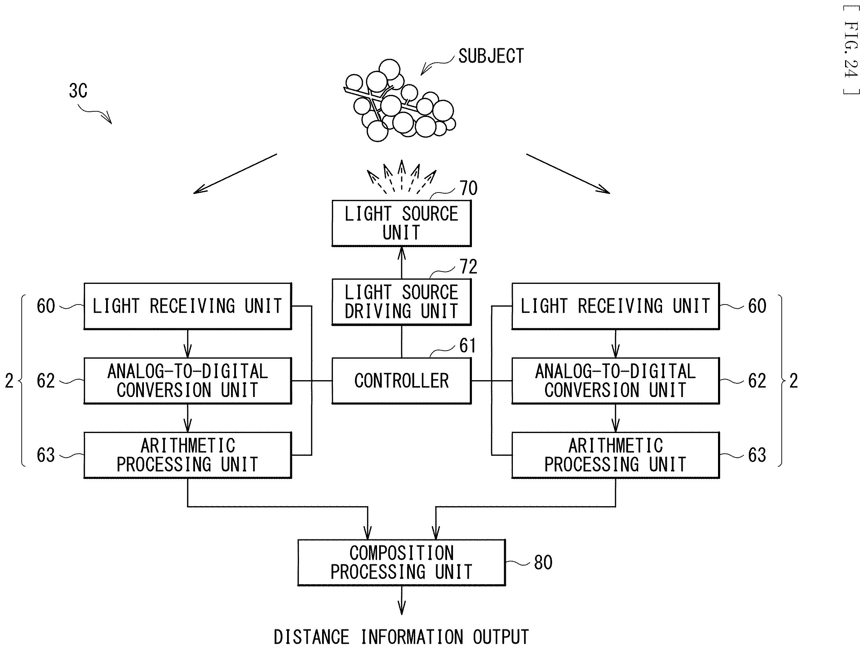

FIG. 24 is a block diagram illustrating an example of a configuration of a distance measurement system 3C. The imaging device 1, 1A, or 1B may be applied to such a distance measurement system 3C. The distance measurement system 3C is configured to also obtain stereoscopic information by disposing a plurality of light receiving units 60 at a distance from each other. It is to be noted that the distance measurement system 3C may be one that projects diffused light similarly to the distance measurement system 3, one that scans light from the light source similarly to the distance measurement system 3A, or one that projects infrared light in a predetermined pattern similarly to the distance measurement system 3B.

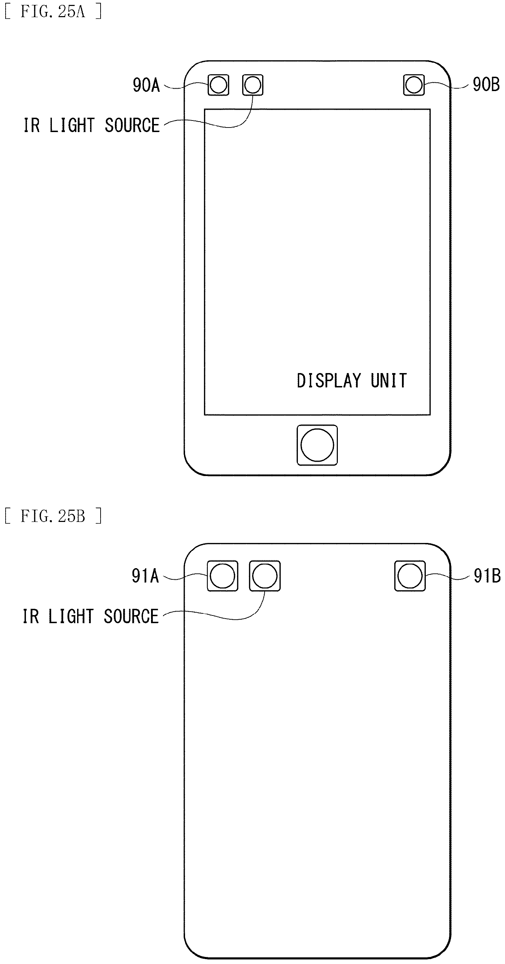

FIGs. 25A and 25B schematically illustrate an example of a planar configuration of a portable electronic apparatus to which any of the imaging devices 1, 1A, and 1B of the foregoing embodiment and the like is applied. The portable electronic apparatus includes, for example, a display unit, front cameras 90A and 90B, rear cameras 91A and 91B, and an IR light source. At least one of the front camera 90A or 90B or the rear camera 91A or 91B is configured by any of the imaging devices 1, 1A, and 1B.

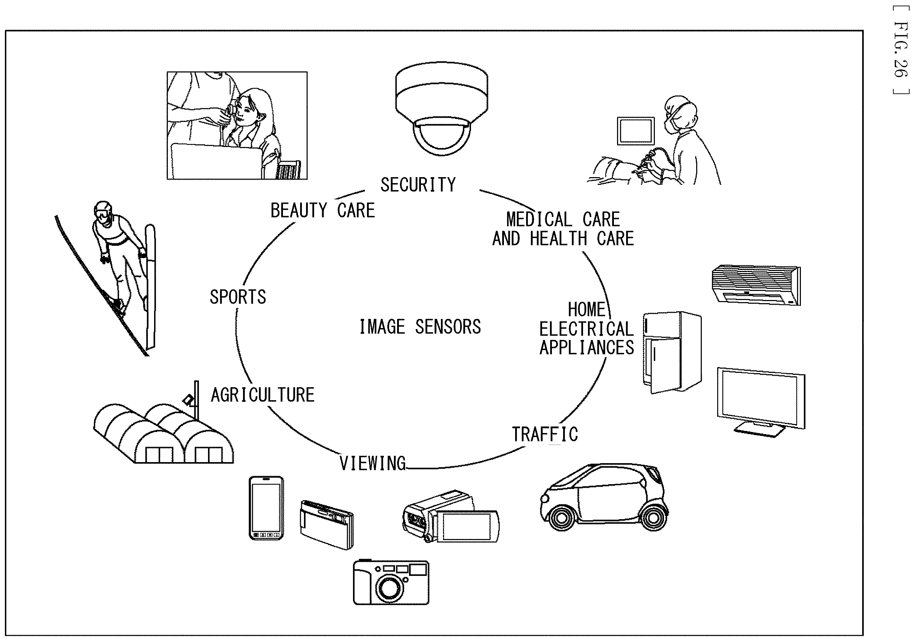

FIG. 26 is a diagram illustrating examples of use of the imaging devices 1, 1A, and 1B of the foregoing embodiment and the like.

The imaging devices 1, 1A, and 1B of the foregoing embodiment and the like are usable in a variety of cases of sensing light such as visible light, infrared light, ultraviolet light, or X-ray as follows, for example.

- Devices that shoot images used for viewing, including digital cameras and portable apparatuses each having a camera function

  - Devices for traffic use including: onboard sensors that shoot images of the front, back, surroundings, inside, and so on of an automobile for safe driving such as automatic stop or for recognition of a driver's state; monitoring cameras that monitor traveling vehicles and roads; and distance measurement sensors that measure vehicle-to-vehicle distances or the like

- Devices for use in home electrical appliances including televisions, refrigerators, and air conditioners to shoot images of the user's gesture and bring the appliances into operation in accordance with the gesture
- Devices for medical care and health care use including endoscopes and devices that shoot images of blood vessels by receiving infrared light
- Devices for security use including monitoring cameras for crime prevention and cameras for individual authentication
- Devices for beauty care use including skin measuring devices that shoot images of skin and microscopes that shoot images of scalp
- Devices for sports use including action cameras and wearable cameras for sports applications, etc.
- Devices for agricultural use including cameras for monitoring the state of fields and crops

<Example of Practical Application to In-Vivo Information Acquisition System>

Further, the technology according to the present disclosure (present technology) is applicable to various products. For example, the technology according to the present disclosure may be applied to an endoscopic surgery system.

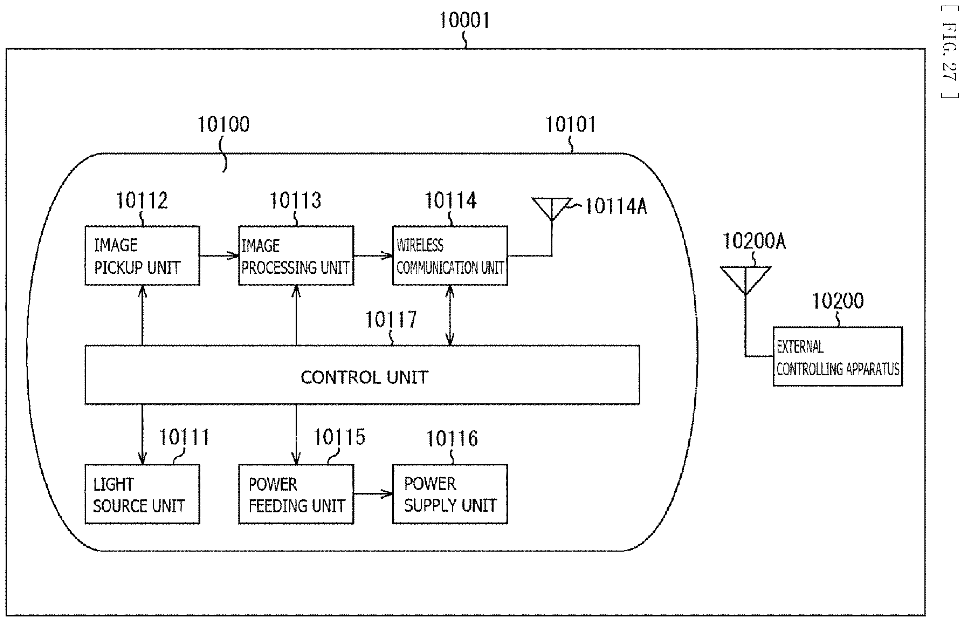

FIG. 27 is a block diagram depicting an example of a schematic configuration of an in-vivo information acquisition system of a patient using a capsule type endoscope, to which the technology according to an embodiment of the present disclosure (present technology) can be applied.

The in-vivo information acquisition system 10001 includes a capsule type endoscope 10100 and an external controlling apparatus 10200.

The capsule type endoscope 10100 is swallowed by a patient at the time of inspection. The capsule type endoscope 10100 has an image pickup function and a wireless communication function and successively picks up an image of the inside of an organ such as the stomach or an intestine (hereinafter referred to as in-vivo image) at predetermined intervals while it moves inside of the organ by peristaltic motion for a period of time until it is naturally discharged from the patient. Then, the capsule type endoscope 10100 successively transmits information of the in-vivo image to the external controlling apparatus 10200 outside the body by wireless transmission.

The external controlling apparatus 10200 integrally controls operation of the in-vivo information acquisition system 10001. Further, the external controlling apparatus 10200 receives information of an in-vivo image transmitted thereto from the capsule type endoscope 10100 and generates image data for displaying the in-vivo image on a display apparatus (not depicted) on the basis of the received information of the in-vivo image.

In the in-vivo information acquisition system 10001, an in-vivo image imaged a state of the inside of the body of a patient can be acquired at any time in this manner for a period of time until the capsule type endoscope 10100 is discharged after it is swallowed.

A configuration and functions of the capsule type endoscope 10100 and the external controlling apparatus 10200 are described in more detail below.

The capsule type endoscope 10100 includes a housing 10101 of the capsule type, in which a light source unit 10111, an image pickup unit 10112, an image processing unit 10113, a wireless communication unit 10114, a power feeding unit 10115, a power supply unit 10116 and a control unit 10117 are accommodated.

The light source unit 10111 includes a light source such as, for example, a light emitting diode (LED) and irradiates light on an image pickup field-of-view of the image pickup unit 10112.

The image pickup unit 10112 includes an image pickup element and an optical system including a plurality of lenses provided at a preceding stage to the image pickup element. Reflected light (hereinafter referred to as observation light) of light irradiated on a body tissue which is an observation target is condensed by the optical system and introduced into the image pickup element. In the image pickup unit 10112, the incident observation light is photoelectrically converted by the image pickup element, by which an image signal corresponding to the observation light is generated. The image signal generated by the image pickup unit 10112 is provided to the image processing unit 10113.

The image processing unit 10113 includes a processor such as a central processing unit (CPU) or a graphics processing unit (GPU) and performs various signal processes for an image signal generated by the image pickup unit 10112. The image processing unit 10113 provides the image signal for which the signal processes have been performed thereby as RAW data to the wireless communication unit 10114.

The wireless communication unit 10114 performs a predetermined process such as a modulation process for the image signal for which the signal processes have been performed by the image processing unit 10113 and transmits the resulting image signal to the external controlling apparatus 10200 through an antenna 10114A. Further, the wireless communication unit 10114 receives a control signal relating to driving control of the capsule type endoscope 10100 from the external controlling apparatus 10200 through the antenna 10114A. The wireless communication unit 10114 provides the control signal received from the external controlling apparatus 10200 to the control unit 10117.

The power feeding unit 10115 includes an antenna coil for power reception, a power regeneration circuit for regenerating electric power from current generated in the antenna coil, a voltage booster circuit and so forth. The power feeding unit 10115 generates electric power using the principle of non-contact charging.

The power supply unit 10116 includes a secondary battery and stores electric power generated by the power feeding unit 10115. In FIG. 27, in order to avoid complicated illustration, an arrow mark indicative of a supply destination of electric power from the power supply unit 10116 and so forth are omitted. However, electric power stored in the power supply unit 10116 is supplied to and can be used to drive the light source unit 10111, the image pickup unit 10112, the image processing unit 10113, the wireless communication unit 10114 and the control unit 10117.

The control unit 10117 includes a processor such as a CPU and suitably controls driving of the light source unit 10111, the image pickup unit 10112, the image processing unit 10113, the wireless communication unit 10114 and the power feeding unit 10115 in accordance with a control signal transmitted thereto from the external controlling apparatus 10200.

The external controlling apparatus 10200 includes a processor such as a CPU or a GPU, a microcomputer, a control board or the like in which a processor and a storage element such as a memory are mixedly incorporated. The external controlling apparatus 10200 transmits a control signal to the control unit 10117 of the capsule type endoscope 10100 through an antenna 10200A to control operation of the capsule type endoscope 10100. In the capsule type endoscope 10100, an irradiation condition of light upon an observation target of the light source unit 10111 can be changed, for example, in accordance with a control signal from the external controlling apparatus 10200. Further, an image pickup condition (for example, a frame rate, an exposure value or the like of the image pickup unit 10112) can be changed in accordance with a control signal from the external controlling apparatus 10200. Further, the substance of processing by the image processing unit 10113 or a condition for transmitting an image signal from the wireless communication unit 10114 (for example, a transmission interval, a transmission image number or the like) may be changed in accordance with a control signal from the external controlling apparatus 10200.

Further, the external controlling apparatus 10200 performs various image processes for an image signal transmitted thereto from the capsule type endoscope 10100 to generate image data for displaying a picked up in-vivo image on the display apparatus. As the image processes, various signal processes can be performed such as, for example, a development process (demosaic process), an image quality improving process (bandwidth enhancement process, a super-resolution process, a noise reduction (NR) process and/or image stabilization process) and/or an enlargement process (electronic zooming process). The external controlling apparatus 10200 controls driving of the display apparatus to cause the display apparatus to display a picked up in-vivo image on the basis of generated image data. Alternatively, the external controlling apparatus 10200 may also control a recording apparatus (not depicted) to record generated image data or control a printing apparatus (not depicted) to output generated image data by printing.

The description has been given above of one example of the in-vivo information acquisition system to which the technology according to the present disclosure is applicable. The technology according to the present disclosure is applicable to, for example, the image pickup unit 10112 among the configurations described above. This makes it possible to improve accuracy of detection.

<Example of Practical Application to Endoscopic Surgery System>

The technology according to the present disclosure (present technology) is applicable to various products. For example, the technology according to the present disclosure may be applied to an endoscopic surgery system.

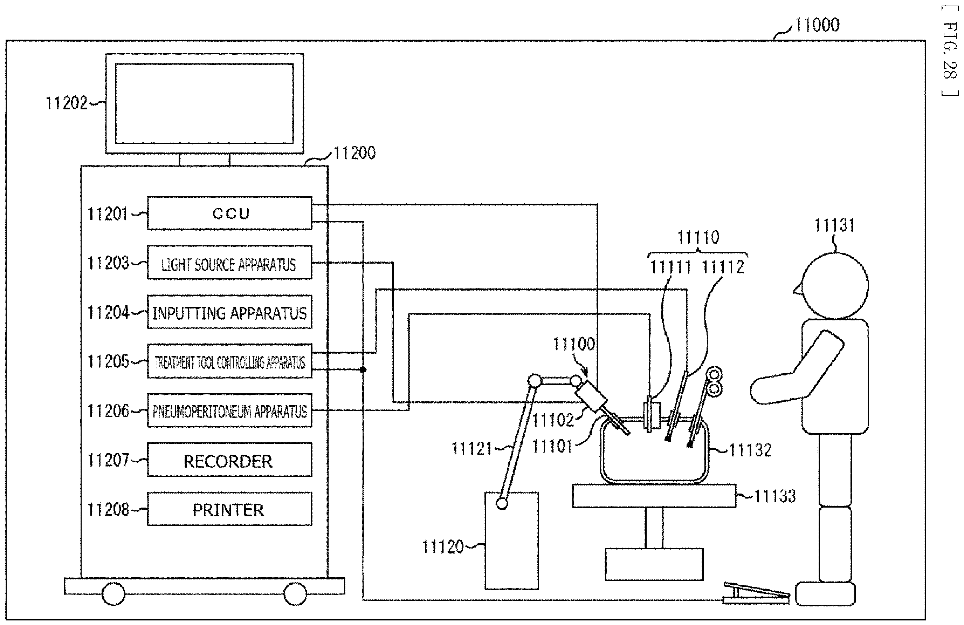

FIG. 28 is a view depicting an example of a schematic configuration of an endoscopic surgery system to which the technology according to an embodiment of the present disclosure (present technology) can be applied.

In FIG. 28, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

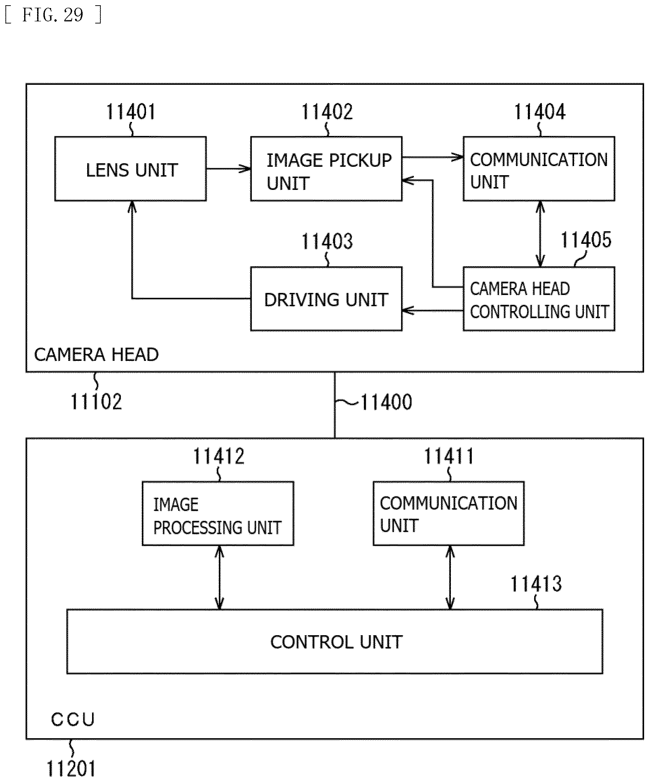

FIG. 29 is a block diagram depicting an example of a functional configuration of the camera head 11102 and the CCU 11201 depicted in FIG. 28.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

The description has been given above of one example of the endoscopic surgery system to which the technology according to the present disclosure is applicable. The technology according to the present disclosure is applicable to, for example, the image pickup unit 11402 among the configurations described above. Applying the technology according to the present disclosure to the image pickup unit 11402 makes it possible to improve accuracy of detection.

It is to be noted that although the endoscopic surgery system has been described as an example here, the technology according to the present disclosure may also be applied to, for example, a microscopic surgery system, and the like.

<Example of Practical Application to Mobile Body>

The technology according to the present disclosure is applicable to various products. For example, the technology according to the present disclosure may be achieved as a device mounted on any type of mobile body such as a vehicle, an electric vehicle, a hybrid electric vehicle, a motorcycle, a bicycle, a personal mobility, an airplane, a drone, a vessel, a robot, a construction machine, or an agricultural machine (tractor).

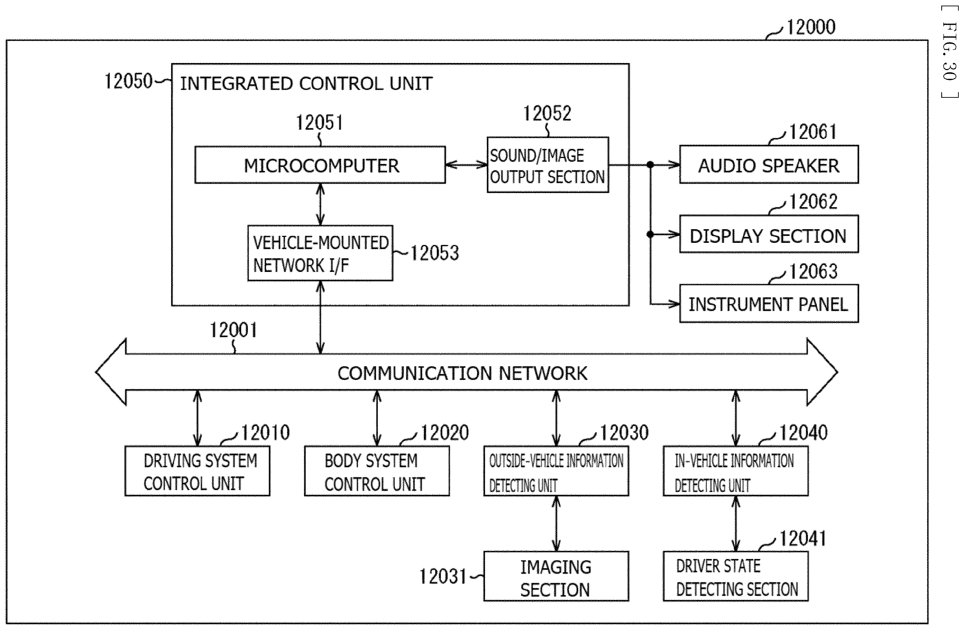

FIG. 30 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 30, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automatic driving, which makes the vehicle to travel autonomously without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 30, an audio speaker 12061, a display section 12062, and an instrument panel 12063 are illustrated as the output device. The display section 12062 may, for example, include at least one of an on-board display and a head-up display.

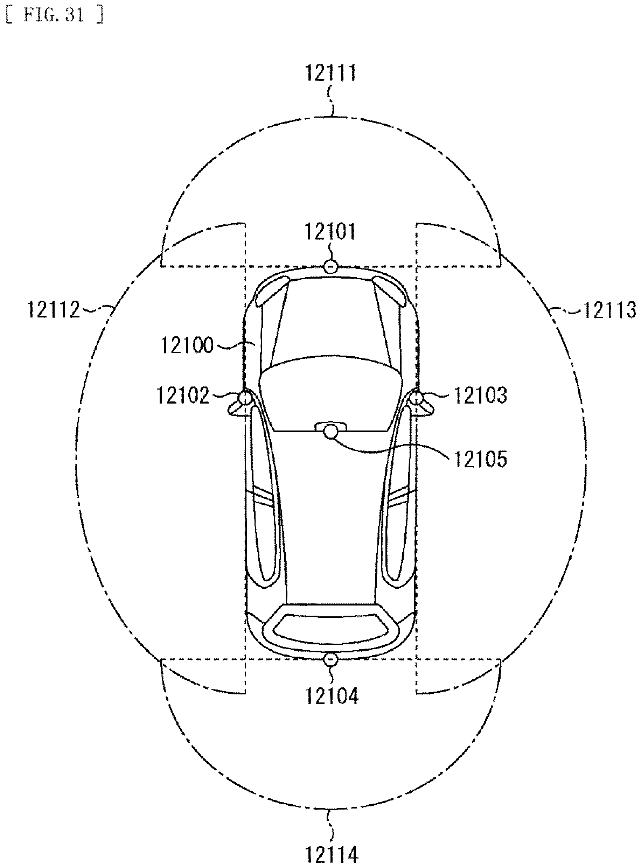

FIG. 31 is a diagram depicting an example of the installation position of the imaging section 12031.

In FIG. 31, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 31 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automatic driving that makes the vehicle travel autonomously without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

The description has been given above of one example of the vehicle control system to which the technology according to the present disclosure is applicable. The technology according to the present disclosure is applicable to, for example, the imaging section 12031 among the configurations described above. Applying the technology according to the present disclosure to the imaging section 12031 makes it possible to obtain a captured image that is easier to see. Hence, it is possible to reduce fatigue of the driver.

The description has been given with reference to the embodiment and modification examples; however, the contents of the present disclosure are not limited to the above-described embodiment and the like, and may be modified in a variety of ways. For example, the configuration of each of the imaging device, the imaging system, and the distance measurement system described in the embodiment above is merely exemplary, and may further include any other component. In addition, the material and thickness of each layer are merely exemplary as well, and are not limited to those described above.

It is to be noted that the effects described in the embodiment and the like above are merely exemplary, and may be any other effects or may further include any other effects.

It is to be noted that the present disclosure may have the following configurations. According to the imaging device and the imaging system having the following configurations, the opening of the light-blocking film satisfies Expression (1). This makes it possible for light reflected or diffracted at the interface between the semiconductor substrate and the wiring layer or in the wiring layer to be hindered from being emitted to the outside of the semiconductor substrate. Accordingly, it is possible to reduce an influence of reflection of light inside the imaging device on imaging information.

(1)
An imaging device including

a semiconductor substrate having a first surface and a second surface opposed to each other, and provided with a plurality of pixels,
a wiring layer which is provided on side of the second surface of the semiconductor substrate and to which a signal is to be transmitted for each of the plurality of pixels,
a light-blocking film opposed to the wiring layer with the semiconductor substrate interposed therebetween and having an opening satisfying Expression (1) below for each of the pixels, and
a waveguide provided on side of the first surface of the semiconductor substrate for each of the plurality of pixels and extending to the opening of the light-blocking film:

$$B < A \ ..... \ (1)$$

where B is an area of the opening in each pixel, and A is an area of the first surface covered with the light-blocking film in each pixel.

(2)
The imaging device according to (1), further including an on-chip lens provided for each of the plurality of pixels and covering the semiconductor substrate with the light-blocking film interposed therebetween, in which
the light-blocking film is provided at a smallest condensed-light diameter portion of the on-chip lens.
(3)
The imaging device according to (1) or (2), in which the light-blocking film satisfies Expression (2) below:

$$A \geq 0.75 \times (A + B) \ ..... \ (2).$$

(4)
The imaging device according to any one of (1) to (3), in which the semiconductor substrate further includes

a separation groove separating adjacent ones of the pixels from each other, and
an embedded light-blocking section provided in a part of the separation groove in a depth direction.

(5)

The imaging device according to (4), in which a dimension H of the embedded light-blocking section in the depth direction satisfies Expression (3) below:

$$H > P/2 \times \tan(a) \quad ..... \quad (3)$$

where P is a dimension of a side of each pixel 50, and a is a critical angle with respect to the separation groove.

(6)

The imaging device according to any one of (1) to (5), in which a material that configures the waveguide has a refractive index higher than a refractive index of a material that configures a surrounding of the waveguide.

(7)

The imaging device according to any one of (1) to (6), in which the light-blocking film includes a metal.

(8)

The imaging device according to any one of (1) to (7), in which the light-blocking film has a stacked structure including a first light-blocking film and a second light-blocking film in this order from side of the semiconductor substrate.

(9)

The imaging device according to (8), in which the first light-blocking film includes a material that reflects light having a wavelength in a near-infrared region.

(10)

The imaging device according to (8) or (9), in which the second light-blocking film includes a material that absorbs light having a wavelength in a near-infrared region.

(11)

The imaging device according to any one of (8) to (10), in which

the first light-blocking film includes aluminum (Al) or copper (Cu), and
the second light-blocking film includes tungsten (W), carbon black, or titanium black.

(12)

The imaging device according to any one of (1) to (11), further including

a photoelectric conversion unit provided in the semiconductor substrate for each of the plurality of pixels,
a first transfer transistor coupled to each of a plurality of the photoelectric conversion units, and
a first floating diffusion capacitance that accumulates signal electric charge transferred from the photoelectric conversion unit via the first transfer transistor.

(13)

The imaging device according to (12), further including

a second transfer transistor coupled to each of the plurality of photoelectric conversion units together with the first transfer transistor, and
a second floating diffusion capacitance that selectively accumulates signal electric charge transferred from the photoelectric conversion unit via the second transfer transistor out of the first transfer transistor and the second transfer transistor.

(14)

The imaging device according to any one of (1) to (13), in which the semiconductor substrate includes a silicon substrate.

(15)

An imaging system including

an imaging device, and
an arithmetic processing unit to which a signal from the imaging device is to be inputted, in which
the imaging device includes

a semiconductor substrate having a first surface and a second surface opposed to each other, and provided with a plurality of pixels,
a wiring layer which is provided on side of the second surface of the semiconductor substrate and to which a signal is to be transmitted for each of the plurality of pixels,
a light-blocking film opposed to the wiring layer with the semiconductor substrate interposed therebetween and having an opening satisfying Expression (1) below for each of the pixels, and
a waveguide provided on side of the first surface of the semiconductor substrate for each of the plurality of pixels and extending to the opening of the light-blocking film:

$$B < A \quad ..... \quad (1)$$

where B is an area of the opening in each pixel, and A is an area of the first surface covered with the light-blocking film in each pixel.

This application claims priority from Japanese Patent Application No. 2019-019629 filed with the Japan Patent Office on February 6, 2019, the entire contents of which are incorporated herein by reference.

It should be understood by those skilled in the art that various modifications, combinations, sub-combinations, and alterations may occur depending on design requirements and other factors insofar as they are within the scope of the appended claims or the equivalents thereof.

**Claims**

1. An imaging device comprising

   a semiconductor substrate having a first surface and a second surface opposed to each other, and provided with a plurality of pixels,
   a wiring layer which is provided on side of the second surface of the semiconductor substrate and to which a signal is to be transmitted for each of the plurality of pixels,
   a light-blocking film opposed to the wiring layer with the semiconductor substrate interposed therebetween and having an opening satisfying Expression (1) below for each of the pixels, and
   a waveguide provided on side of the first surface of the semiconductor substrate for each of the plurality of pixels and extending to the opening of the light-blocking film:

   $$B < A \ ..... \ (1)$$

   where B is an area of the opening in each pixel, and A is an area of the first surface covered with the light-blocking film in each pixel.

2. The imaging device according to claim 1, further comprising an on-chip lens provided for each of the plurality of pixels and covering the semiconductor substrate with the light-blocking film interposed therebetween, wherein
   the light-blocking film is provided at a smallest condensed-light diameter portion of the on-chip lens.

3. The imaging device according to claim 1, wherein the light-blocking film satisfies Expression (2) below:

   $$A \geq 0.75 \times (A + B) \ ..... \ (2).$$

4. The imaging device according to claim 1, wherein the semiconductor substrate further includes

   a separation groove separating adjacent ones of the pixels from each other, and
   an embedded light-blocking section provided in a part of the separation groove in a depth direction.

5. The imaging device according to claim 4, wherein a dimension H of the embedded light-blocking section in the depth direction satisfies Expression (3) below:

   $$H > P/2 \times \tan(a) \ ..... \ (3)$$

   where P is a dimension of a side of each pixel 50, and a is a critical angle with respect to the separation groove.

6. The imaging device according to claim 1, wherein a material that configures the waveguide has a refractive index higher than a refractive index of a material that configures a surrounding of the waveguide.

7. The imaging device according to claim 1, wherein the light-blocking film includes a metal.

8. The imaging device according to claim 1, wherein the light-blocking film has a stacked structure including a first light-blocking film and a second light-blocking film in this order from side of the semiconductor substrate.

9. The imaging device according to claim 8, wherein the first light-blocking film includes a material that reflects light having a wavelength in a near-infrared region.

10. The imaging device according to claim 8, wherein the second light-blocking film includes a material that absorbs light having a wavelength in a near-infrared region.

11. The imaging device according to claim 8, wherein

    the first light-blocking film includes aluminum (Al) or copper (Cu), and
    the second light-blocking film includes tungsten (W), carbon black, or titanium black.

12. The imaging device according to claim 1, further comprising

    a photoelectric conversion unit provided in the semiconductor substrate for each of the plurality of pixels,
    a first transfer transistor coupled to each of a plurality of the photoelectric conversion units, and
    a first floating diffusion capacitance that accumulates signal electric charge transferred from the photoelectric conversion unit via the first transfer transistor.

**13.** The imaging device according to claim 12, further comprising

a second transfer transistor coupled to each of the plurality of photoelectric conversion units together with the first transfer transistor, and a second floating diffusion capacitance that selectively accumulates signal electric charge transferred from the photoelectric conversion unit via the second transfer transistor out of the first transfer transistor and the second transfer transistor.

**14.** The imaging device according to claim 1, wherein the semiconductor substrate comprises a silicon substrate.

**15.** An imaging system comprising

an imaging device, and an arithmetic processing unit to which a signal from the imaging device is to be inputted, wherein the imaging device includes

a semiconductor substrate having a first surface and a second surface opposed to each other, and provided with a plurality of pixels, a wiring layer which is provided on side of the second surface of the semiconductor substrate and to which a signal is to be transmitted for each of the plurality of pixels, a light-blocking film opposed to the wiring layer with the semiconductor substrate interposed therebetween and having an opening satisfying Expression (1) below for each of the pixels, and a waveguide provided on side of the first surface of the semiconductor substrate for each of the plurality of pixels and extending to the opening of the light-blocking film:

$$B < A \ ..... \ (1)$$

where B is an area of the opening in each pixel, and A is an area of the first surface covered with the light-blocking film in each pixel.

[ FIG. 1 ]

[ FIG. 2 ]

[ FIG. 3 ]

[ FIG. 4 ]

[ FIG. 5 ]

[ FIG. 6 ]

[ FIG. 7 ]

[ FIG. 8 ]

[ FIG. 9 ]

[ FIG. 10A ]

[ FIG. 10B ]

[ FIG. 11 ]

[ FIG. 12 ]

[ FIG. 13 ]

[ FIG. 14 ]

[ FIG. 15 ]

[ FIG. 16 ]

[ FIG. 17 ]

[ FIG. 18 ]

[ FIG. 19 ]

[ FIG. 20A ]

110A

1, 1A, 1B

PIXEL
REGION

CONTROL
CIRCUIT

110B

LOGIC CIRCUIT 110C,
DRIVE CIRCUIT 110D

[ FIG. 20B ]

CONTROL
CIRCUIT

110B

1, 1A, 1B

PIXEL REGION

110A

LOGIC
CIRCUIT,
DRIVE
CIRCUIT

110C, 110D

[ FIG. 20C ]

1, 1A, 1B

PIXEL REGION

110A

CONTROL
CIRCUIT

110B

LOGIC CIRCUIT,
DRIVE CIRCUIT

110C, 110D

[ FIG. 21 ]

EP 3 923 331 A1

[ FIG. 22 ]

EP 3 923 331 A1

SUBJECT

3A

SCANNING
LIGHT

81

82

73 — SCANNING UNIT

70 — LIGHT SOURCE UNIT

72 — LIGHT SOURCE
DRIVING UNIT

CONTROLLER

61

LIGHT RECEIVING UNIT — 60

ANALOG-TO-DIGITAL
CONVERSION UNIT — 62

ARITHMETIC
PROCESSING UNIT — 63

DISTANCE INFORMATION
OUTPUT

2

[ FIG. 23 ]

[ FIG. 24 ]

EP 3 923 331 A1

SUBJECT

3C

70
LIGHT SOURCE
UNIT

72
LIGHT SOURCE
DRIVING UNIT

60 LIGHT RECEIVING UNIT

61
CONTROLLER

LIGHT RECEIVING UNIT 60

2

62 ANALOG-TO-DIGITAL
CONVERSION UNIT

ANALOG-TO-DIGITAL
CONVERSION UNIT 62

2

63 ARITHMETIC
PROCESSING UNIT

ARITHMETIC
PROCESSING UNIT 63

COMPOSITION
PROCESSING UNIT 80

DISTANCE INFORMATION OUTPUT

EP 3 923 331 A1

[ FIG.25A ]

[ FIG.25B ]

43

[ FIG. 26 ]

[ FIG. 27 ]

EP 3 923 331 A1

10001

10100

10101

10112

IMAGE
PICKUP UNIT

10113

IMAGE
PROCESSING UNIT

10114

WIRELESS
COMMUNICATION UNIT

10114A

10200A

10200

EXTERNAL
CONTROLLING APPARATUS

10117

CONTROL UNIT

10111

LIGHT
SOURCE UNIT

10115

POWER
FEEDING UNIT

10116

POWER
SUPPLY UNIT

[ FIG. 28 ]

EP 3 923 331 A1

[ FIG. 29 ]

```
┌─────────────────────────────────────────────────────────────────────────┐
│                                                                           │
│   11401              11402                        11404                    │
│  ┌──────────┐      ┌─────────────┐              ┌──────────────┐          │
│  │          │      │ IMAGE PICKUP│───────────▶  │COMMUNICATION │          │
│  │ LENS UNIT│─────▶│ UNIT        │              │UNIT          │          │
│  │          │      │             │◀─────────┐   │              │          │
│  └──────────┘      └─────────────┘          │   └──────────────┘          │
│        ▲                                     │          ▲                  │
│        │              11403                  │          │     11405        │
│        │            ┌─────────────┐          │   ┌──────────────┐          │
│        │            │             │          │   │CAMERA HEAD   │          │
│        └────────────│ DRIVING UNIT│          └───│CONTROLLING   │          │
│                     │             │◀─────────────│UNIT          │          │
│                     └─────────────┘              └──────────────┘          │
│  CAMERA HEAD                                                               │
└─────────────────────────────────────────────────────────────────────────┘
     11102                      │
                                │~11400
┌───────────────────────────────┼──────────────────────────────────────────┐
│                                                                           │
│           11412                           11411                            │
│         ┌─────────────┐                 ┌──────────────┐                   │
│         │IMAGE        │                 │COMMUNICATION │                   │
│         │PROCESSING   │                 │UNIT          │                   │
│         │UNIT         │                 │              │                   │
│         └─────────────┘                 └──────────────┘                   │
│               ▲                                ▲        11413              │
│               │                                │                           │
│               ▼                                ▼                           │
│         ┌─────────────────────────────────────────────────────┐           │
│         │                  CONTROL UNIT                        │           │
│         └─────────────────────────────────────────────────────┘           │
│                                                                           │
│  CCU                                                                      │
└───────────────────────────────────────────────────────────────────────────┘
     11201
```

[ FIG. 30 ]

[ FIG. 31 ]

### INTERNATIONAL SEARCH REPORT

International application No.

PCT/JP2020/002238

**A. CLASSIFICATION OF SUBJECT MATTER**
Int.Cl. H01L27/146(2006.01)i, H04N5/369(2011.01)i
FI: H01L27/146A, H04N5/369, H01L27/146D

According to International Patent Classification (IPC) or to both national classification and IPC

**B. FIELDS SEARCHED**

Minimum documentation searched (classification system followed by classification symbols)
Int.Cl. H01L27/146, H04N5/369

Documentation searched other than minimum documentation to the extent that such documents are included in the fields searched
Published examined utility model applications of Japan      1922–1996
Published unexamined utility model applications of Japan    1971–2020
Registered utility model specifications of Japan            1996–2020
Published registered utility model applications of Japan    1994–2020

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2012-124377 A (SONY CORPORATION) 28.06.2012 (2012-06-28), paragraphs [0024]-[0139], fig. 1, 21 | 1-15 |
| Y | JP 2000-059688 A (CANON INC.) 25.02.2000 (2000-02-25), paragraphs [0077], [0078], fig. 10 | 1-15 |
| Y | JP 11-097655 A (TOSHIBA CORPORATION) 09.04.1999 (1999-04-09), paragraphs [0034]-[0041], fig. 1 | 2 |
| Y | JP 2018-206837 A (SONY SEMICONDUCTOR SOLUTIONS CORP.) 27.12.2018 (2018-12-27), paragraph [0066], fig. 9 | 4, 5 |
| Y | WO 2018/235416 A1 (SONY SEMICONDUCTOR SOLUTIONS CORP.) 27.12.2018 (2018-12-27), paragraphs [0083]-[0085], fig. 62, 63 | 8-11 |
| Y | JP 2015-186007 A (CANON INC.) 22.10.2015 (2015-10-22), paragraphs [0011], [0012], fig. 2 | 12, 13 |

☒ Further documents are listed in the continuation of Box C.      ☒ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 16.03.2020 | 31.03.2020 |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

**INTERNATIONAL SEARCH REPORT**

| International application No. |
|---|
| PCT/JP2020/002238 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 11-087677 A (NIKON CORPORATION) 30.03.1999 (1999-03-30), paragraphs [0021]-[0023], fig. 1 | 1-15 |

Form PCT/ISA/210 (second sheet) (January 2015)

**INTERNATIONAL SEARCH REPORT**
Information on patent family members

International application No.

PCT/JP2020/002238

```
JP 2012-124377 A    28.06.2012    US 2012/0147208 A1
                                  paragraphs [0067]-[0199], fig. 1, 21
                                  CN 102569315 A
                                  TW 201230313 A

JP 2000-059688 A    25.02.2000    (Family: none)

JP 11-097655 A      09.04.1999    (Family: none)

JP 2018-206837 A    27.12.2018    (Family: none)

WO 2018/235416 A1   27.12.2018    (Family: none)

JP 2015-186007 A    22.10.2015    (Family: none)

JP 11-087677 A      30.03.1999    (Family: none)
```

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017150893 A
- JP 2018117117 A
- JP 2019019629 A